# EUROPÄISCHE PATENTSCHRIFT

(11) **EP 1 057 756 B1**
(45) Veröffentlichungstag und Bekanntmachung des Hinweises auf die Patenterteilung: **11.08.2004**
(21) Anmeldenummer: 00201920.6
(22) Anmeldetag: 30.05.2000
(51) Int. Cl.: B65G 47/51, B65G 11/06, B65G 27/02, H05K 13/00

(54) **Speichereinrichtung für Bauelemente**
Storage device for components
Dispositif de stockage pour composants

(30) Priorität: 05.06.1999 DE 19925789
(43) Veröffentlichungstag der Anmeldung: 06.12.2000
(73) Patentinhaber: Philips Intellectual Property & Standards GmbH, 20099 Hamburg (DE); Koninklijke Philips Electronics N.V., 5621 BA Eindhoven (NL)
(72) Erfinder: Steffens, Engelbert, Philips Corp.Intel.Prop. GmbH, 52064 Aachen (DE); Martens, Jörg, Philips Corp. Intel. Prop. GmbH, 52064 Aachen (DE)
(74) Vertreter: Volmer, Georg, Dipl.-Ing.

(56) Entgegenhaltungen:
- FR-A- 2 693 178
- GB-A- 1 554 170

## Beschreibung

Die Erfindung bezieht sich auf eine Speichereinrichtung mit einem Kanal zur Aufnahme von Bauelementen nach dem Oberbegriff des Anspruchs 1.

Aus der deutschen Offenlegungsschrift 42 20 700 ist eine Speichereinrichtung für elektronische Bauelemente bekannt, die einen im wesentlichen plattenförmigen Körper umfaßt, in dessen Inneren ein im wesentlichen spiralförmiger Kanal und eine Öffnung als Fortsetzung des spiralförmigen Kanals ausgebildet sind, damit der Kanal mit dem Äußeren des plattenförmigen Körpers in Verbindung steht. Im Kanal dieser Speichereinrichtung können elektronische Bauelemente in vorbestimmter Reihenfolge gespeichert werden. Zum Zuführen von elektronischen Bauelementen werden Vibrationen an die Speichereinrichtung angelegt und die Bauelemente über eine Vibrator- Zuführeinrichtung zugeführt. Diese Speichereinrichtung kann so ausgebildet sein, daß sie als Versorgungsquelle verwendet werden kann, um die elektronischen Bauelemente einem Montagekopf einer automatischen Montagevorrichtung zuzuführen, um die elektronischen Bauelemente auf gedruckten Schaltungsplatinen zu montieren. Dazu weist die Speichereinrichtung insbesondere Luftzufuhröffnungen auf, die mit einer Luftversorgungsquelle verbunden werden, durch die Luft in den spiralförmigen Kanal so eingeführt wird, daß die elektronischen Bauelemente längs des spiralförmigen Kanals zu der Öffnung der Speichereinrichtung hin vorwärts bewegt werden können. Durch die von der Luftversorgungsquelle in den spiralförmigen Kanal durch die Luftzufuhröffnungen zugeführte Luft können dann die elektronischen Bauelemente aus der Speichereinrichtung herausbefördert werden.

Derartige Speichereinrichtungen haben gegenüber einer Aufreihung elektronischer Bauelemente auf sogenannten "Tapes" o.dgl. den Vorteil der Wiederverwendbarkeit. Sie sind einfach zu handhaben und mechanisch robust.

Es hat sich jedoch gezeigt, daß der aus der DE-OS 42 20 700 bekannten Bauform der Speichereinrichtung in der Handhabung noch einige Nachteile anhaften. Zwar hat die plattenförmige Gestaltung des Körpers der Speichereinrichtung gemäß DE-OS 42 20 700 insoweit den Vorteil, daß sie hochkantstehend einen nur relativ geringen Platzbedarf auf einer Montagevorrichtung der beschriebenen Art benötigt. Dem stehen jedoch als Nachteil der zwangsweise von der Öffnung des Kanals beginnend zum Inneren der Speichereinrichtung hin sich kontinuierlich verringernde Radius des Kanals sowie die Tatsache entgegen, daß dieser Kanal nur von der einzigen Öffnung aus befüllt und wieder entleert werden kann. Dabei sind für die Befüllung und die Entleerung unterschiedliche Einrichtungen erforderlich, nämlich zum einen eine Vibrationseinrichtung, zum anderen eine Drucklufteinrichtung. Allein die letztgenannte Eigenschaft vergrößert den Handhabungsaufwand der bekannten Speichereinrichtung erheblich. Der sich zum Inneren des plattenförmigen Körpers hin verringernde Radius des Kanals der Speichereinrichtung kann dazu führen, daß elektronische Bauelemente bestimmter äußerer Abmessungen, die in Bereichen des Kanals mit größerem Radius noch einwandfrei geführt werden, in den Bereichen des Kanals mit geringem Radius sich nur noch schwierig fortbewegen lassen oder zum Verklemmen neigen. Es kann dann zu Schwierigkeiten beim Befüllen und insbesondere beim Entleeren der Speichereinrichtung während des Einsatzes in der genannten Montagevorrichtung kommen.

Aus der DE 693 14 337 T2, die auf die Prioritätsanmeldung mit der Veröffentlichungsnummer FR-A-2 693 178 zurückgeht, ist eine Lade- und Abgabevorrichtung für Federn und eine damit bewerkstelligte Federverpackung bekannt. Diese Vorrichtung, die zum kontinuierlichen Laden, Transportieren und Zuteilen von Schraubenfedern eingerichtet ist, umfaßt ein erstes und ein zweites Vibrationsmittel sowie einen weichen Schlauch, in dem die Federn koaxial nebeneinander angeordnet werden, wobei der Schlauch von großer Länge und auf einem abnehmbaren Träger aufgerollt ist. Das erste Vibrationsmittel ist mit Befestigungsmitteln für den abnehmbaren Träger versehen, wobei zum Laden von Federn der Schlauch an seinem freien Ende Mittel zum Verbinden mit einer Maschine zum Herstellen der Federn aufweist. Das zweite Vibrationsmittel ist vom gleichen Typ wie das erste Vibrationsmittel, jedoch verschieden hiervon ebenfalls mit Mitteln zum Befestigen an dem abnehmbaren Träger versehen. Die Mittel zum Verbinden des Schlauches sind ebenfalls mit einer Maschine zum Verteilen von Federn, insbesondere einem Schreibstiftzuteiler verbindbar. In der hier beschriebenen Vorrichtung ist der Schlauch um eine Bobine gerollt, und die Federn wandern beim Laden im Inneren des Schlauches unter der Wirkung der Vibrationen entsprechend einer "Schraube", bis sie am eingerollten Ende des Schlauches ankommen, wobei die nachfolgenden Federn gegen die vorhergehenden Federn in dem Maße des Ladens zur Anlage gelangen. Zum Entladen wandern die Federn unter der Wirkung der Vibrationen eines Vibrators, der mit einer Polarität umgekehrt zu derjenigen des Ladens in Gang gesetzt ist, im Sinn von innen nach außen, was einem "Herausschrauben" entspricht.

Aus der europäischen Patentanmeldung 0 108 401 ist ein Magazin für kleine elektronische Bauelemente bekannt, das aus einem rohrförmigen Körper besteht, dessen Hauptteil zu einer Spirale gewunden ist und dessen Endteile sich in Achsrichtung dieser Spirale erstrekken. Der rohrförmige Körper kann um einen Spulenrahmen gewickelt sein, bestehend aus einem Zylinder mit zwei Begrenzungsscheiben, an denen jeweils eine Stummelwelle angebracht ist. Die Endteile des rohrförmigen Körpers sind durch Öffnungen in den Begrenzungsscheiben heraus und in das Innere der Stummelwellen geführt, die an ihrem jeweiligen Ende Trichteröffnungen aufweisen, zu denen Bohrungen führen, in die die Endteile münden. Dieses Magazin ist insbesondere für die Speicherung von solchen Dioden vorgesehen, deren Elektroden aus Metallflächen bestehen und die zum direkten Einlöten in gedruckte Schaltungen ausgebildet sind. Diese Dioden bestehen aus einem isolierenden Zylinder, der den Halbleiterkristall enthält und durch zwei Metallteile verschlossen ist, deren Oberflächen als Elektroden dienen. Ein derartiger Zylinder wird zunächst an eine gedruckte Schaltung gebondet und dann durch Schwallöten an der Printplatte befestigt und mit der Schaltung fest verbunden. Vor der Verwendung derartiger Bauelemente ist es erforderlich, daß man die Zylinder nicht nur entlang ihrer Achse, sondern auch anhand der Polung der Dioden ausrichtet. Der rohrförmige Körper soll nun so beschaffen sein, daß die elektronischen Bauteile hindurchgleiten und so geführt werden, daß sie ihre Ausrichtung beibehalten.

Ein derartiges Magazin, welches eine ausdrücklich behelfsmäßige Gestaltung und Herstellung aufweist, zeigt sich als für eine Speicherung chipartiger, elektronischer Bauelemente, wie sie von der modernen Halbleitertechnik gefordert wird, ungeeignet. Der rohrförmige Körper des bekannten Magazins erlaubt lediglich eine Ausrichtung der zylindrischen Bauelemente bezüglich ihrer Längsachse. Die Ausrichtung chipartiger Bauelemente umfaßt jedoch auch das Verhindern einer unbestimmbaren Drehung entlang einer solchen Längsachse. Bei dem bekannten Magazin kommt es auf eine derartige Drehung bzw. Lagedefinition nicht an. Außerdem besteht in den Trichteröffnungen der Stummelwellen die Gefahr, daß die gespeicherten Bauelemente an diesen Stellen aus der gewünschten Ausrichtung geraten. Zudem weist der rohrförmige Körper sowohl an seinen Endteilen als auch entlang seines Hauptteils wechselnde, undefinierte Krümmungsradien auf, die bei der beschriebenen, behelfsmäßigen Herstellung des Magazins von Exemplar zu Exemplar unterschiedlich ausfallen können. Damit ist die Führung von Bauelementen in dem rohrförmigen Körper noch unsicherer als in dem im wesentlichen spiralförmigen Kanal, wie er in der DE-OS 42 20 700 beschrieben ist. Außerdem können durch das Aufwickeln des rohrförmigen Körpers auf dem Spulenrahmen zumindest einige Abschnitte des Hauptteils des rohrförmigen Körpers nicht mehr von Außen zugreifbar sein. Treten dann bei den beschriebenen undefinierten Krümmungsradien Unregelmäßigkeiten in der Förderung der elektronischen Bauelemente entlang des rohrförmigen Körpers auf, ist möglicherweise eine Behebung dieser Unregelmäßigkeiten, beispielsweise Verklemmungen, nur mit großem Aufwand, möglicherweise nur durch Zerstörung des rohrförmigen Körpers, behebbar.

Darüber hinaus ist die Herstellung des aus der EP 0 108 401 A2 bekannten Magazins aufgrund seiner behelfsmäßigen Ausführung letztlich nicht nur teurer als die Herstellung der erfindungsgemäßen Speichereinrichtung, die mit Fertigungsmitteln der Großserien-Herstellung sehr einfach und kostengünstig durchgeführt werden kann, sondern das bekannte Magazin zeigt auch eine sperrige Gestaltung, was sich ungünstig bei einer Handhabung auf modernen Halbleiterfertigungsanlagen auswirkt.

Diese Nachteile haften zum ganz überwiegenden Teil auch der aus der DE 693 14 337 T2 bzw. der FR-A-2 693 178 bekannten Vorrichtung an.

Aus der GB-A-1 554 170 ist ein Speicher zum Aufnehmen und Zuführen einer Mehrzahl von Artikeln bekannt, der spurdefinierende Mittel, Fördermittel, die eine Mehrzahl luftstromformender Mittel entlang der spurdefinierenden Mittel enthalten, um entlang dieser die Artikel zu fördern, und wenigstens einen Ausgang des Speichers umfaßt. Darin sind die spurdefinierenden Mittel derart angeordnet, daß sie die Speicherung entlang eines fortlaufenden, mehrlagigen, dreidimensionalen, quasi-schraubenförmigen Weges vorsehen, der aus einer Reihe gleicher, mit ihren Enden aneinander anschließender Sektoren gebildet werden, deren jeder einen tangential angeordneten Eingang aufweist. Als zu speichernde Artikel werden insbesondere Filmpatronen genannt.

Auch für diesen Speicher ist eine in jeder Bewegungsrichtung lagerichtige Speicherung chipartiger elektronischer Bauelemente nicht beschrieben. Außerdem zeigt der beschriebene Speicher einen sehr komplizierten Aufbau.

Die Erfindung hat die Aufgabe, eine Speichereinrichtung zur Aufnahme chipartiger elektronischer Bauelemente zu schaffen, durch die die vorstehend beschriebenen Nachteile der bekannten Speichereinrichtung behoben werden.

Diese Aufgabe wird erfindungsgemäß bei einer Speichereinrichtung der gattungsgemäßen Art durch die kennzeichnenden Merkmale des Anspruchs 1 gelöst.

Bei der erfindungsgemäßen Speichereinrichtung ist der Kanal zur Aufnahme der Bauelemente zwischen einem ersten und einem zweiten Ende wenigstens weitgehend entlang einer Schraubenlinie geführt ist.

Während der Radius eines spiralförmigen Kanals entlang der Längsausdehnung dieses Kanals vom Ende des Kanals aus zwangsläufig fortwährend geringer wird, kann der Radius einer Schraubenlinie den Erfordernissen beliebig angepaßt werden. Als Schraubenlinie in diesem Sinne soll dabei eine räumliche Kurve verstanden werden, die sich in Zylinderkoordinaten, bestehend aus Längskoordinate, Radius und Drehwinkel, wie folgt beschreiben läßt:
Die Längskoordinate ist eine monoton wachsende Funktion des Drehwinkels, wohingegen der Radius in der allgemeinsten Form der so definierten Schraubenlinie eine stetige Funktion des Drehwinkels ist, deren Funktionswerte stets positiv sind. Im Gegensatz zu einer Spirale, die sich in einer Ebene ausbreitet, stellt eine Schraubenlinie ein dreidimensionales Gebilde dar. Bei einer solchen Schraubenlinie kann der Radius frei gewählt werden. Ein schraubenlinienförmiger Kanal kann dann über seiner gesamten Länge mit einem Radius ausgebildet werden, der eine problemlose Führung der Bauelemente in vorgegebener Ausrichtung ohne deren ungewollte Änderung und ohne Stocken oder Verklemmen gewährleistet. Ein schraubenlinienförmiger Kanal kann auch von seinen beiden Enden her zugänglich und zugleich über seiner gesamten Länge überwachbar, z.B. einsehbar, ausgebildet werden. Dadurch können Befüllen und Entleeren der Speichereinrichtung mit derselben Bewegungsrichtung der Bauelemente im Kanal vorgenommen werden. Unregelmäßigkeiten im Betrieb lassen sich schneller und leichter erkennen und beheben. Außerdem kann beispielsweise ein erstes Ende eines solchen schraubenlinienförmigen Kanals in einer erfindungsgemäßen Speichereinrichtung einfach mit einem zweiten Ende eines zweiten Exemplars einer erfindungsgemäßen Speichereinrichtung räumlich derart angeordnet werden, daß ein einfacher Übergang von Bauelementen zwischen den Kanälen der beiden Exemplare der Speichereinrichtung möglich werden.

Bei einer derartigen Schraubenlinie wird die Längskoordinate der genannten Zylinderkoordinaten hier auch als Schraubenachse bezeichnet.

Für die Verbindung der Kanalenden verschiedener Exemplare der erfindungsgemäßen Speichereinrichtung, d.h. für die Stapelbarkeit, ist es vorteilhaft, daß der schraubenlinienförmige Kanal an seinen Enden wenigstens weitgehend übereinstimmende Radien aufweist.

In einer vorteilhaften Ausgestaltung der erfindungsgemäßen Speichereinrichtung ist der Kanal im wesentlichen entlang einer zylindrischen Schraubenlinie geführt. Unter einer zylindrischen Schraubenlinie soll eine Schraubenlinie verstanden werden, die zumindest im wesentlichen entlang der Mantelfläche eines Zylinders geführt ist. Unter einem Zylinder ist dabei ein Körper zu verstehen, der von einer Zylinderfläche mit geschlossener Leitkurve und zwei Ebenen begrenzt wird, die im wesentlichen zueinander parallel laufen. Als Zylinderfläche wird dabei die Fläche verstanden, die von einer Geraden, der sogenannten Erzeugenden, aufgespannt wird, wenn diese Erzeugende ohne Veränderung ihrer Richtung längs einer gekrümmten, vorzugsweise geschlossenen, Linie, der sogenannten Leitkurve, gleitet.

Bei der erfindungsgemäßen Speichereinrichtung kann die beschriebene Leitkurve der Zylinderfläche, entlang der sich die zylindrische Schraubenlinie erstreckt, vorzugsweise eine elliptische oder eine ovale Form aufweisen. Dadurch kann in einer Richtung senkrecht zur Schraubenachse die Schraubenlinie einen geringeren Durchmesser aufweisen als in einer vorzugsweise senkrecht dazu gerichteten, zweiten radialen Richtung senkrecht zur Schraubenachse. Auf diese Weise kann eine Speichereinrichtung mit vergrößerter Speicherkapazität ohne Vergrößerung einer der Abmessungen senkrecht zur Schraubenachse erhalten werden.

Eine besonders einfach gestaltete Speichereinrichtung gemäß der Erfindung wird erhalten, wenn der Kanal im wesentlichen entlang einer kreiszylindrischen Schraubenlinie geführt ist. Diese kreiszylindrische Schraubenlinie erstreckt sich entlang der Mantelfläche eines Kreiszylinders. Ein so ausgestalteter Kanal weist an jeder Stelle einer Längsausdehnung den selben Radius und bezüglich der Schraubenachse auch die selbe Steigung bzw. Ganghöhe auf. Dadurch ist eine derart ausgestaltete Speichereinrichtung nicht nur einfach herstellbar, sondern weist für die darin gespeicherten Bauelemente an jeder Stelle des Kanals die selben Eigenschaften auf. Dadurch werden für die Bewegungen der Bauelemente im Kanal besonders günstige, gleichförmige Bedingungen geschaffen, die eine Handhabung der Bauelemente erleichtern.

Bei einer derartigen, kreiszylindrischen Schraubenlinie wird die Leitkurve der Zylinderfläche, entlang der die Schraubenlinie geführt ist, durch einen Kreis gebildet, deren Mittelpunkt auf der Schraubenachse liegt.

In der erfindungsgemäßen Speichereinrichtung steht der Kanal an wenigstens einem seiner Enden durch eine Öffnung mit der äußeren Umgebung der Speichereinrichtung in Verbindung. Vorzugsweise ist an jedem der Enden des Kanals eine derartige Öffnung vorgesehen. Dabei kann eine erste dieser Öffnungen am ersten der Enden des Kanals vorzugsweise zum Befüllen der Speichereinrichtung mit Bauelementen dienen, wo hingegen vorteilhaft eine zweite dieser Öffnungen am zweiten der Enden des Kanals zum Entladen der Bauelemente aus der Speichereinrichtung vorgesehen ist. Die Bauelemente bewegen sich dann innerhalb des Kanals stets von der ersten zur zweiten Öffnung. Damit lassen sich Vorrichtungen, in denen das Befüllen der Speichereinrichtung vorgenommen werden kann, zumindest in wesentlichen Merkmalen denjenigen Vorrichtungen gleich gestalten, die zum Entladen der Bauelemente aus der Speichereinrichtung herangezogen werden können. Dies stellt eine bedeutende Vereinfachung der Handhabung der erfindungsgemäßen Speichereinrichtung dar.

Die erfindungsgemäße Speichereinrichtung umfaßt eine erste, sockelartige Ausformung im Bereich des ersten Endes des Kanals und eine zweite, sockelartige Ausformung im Bereich des zweiten Endes des Kanals, welche sockelartigen Ausformungen zueinander komplementär gestaltet sind und wobei die zweite, sockelartige Ausformung eines ersten Exemplars der Speichereinrichtung mit der ersten, sockelartigen Ausformung eines zweiten Exemplars der Speichereinrichtung zum für die Bauelemente durchgängigen Verbinden der zweiten Öffnung am zweiten Ende des Kanals der ersten Speichereinrichtung mit der ersten Öffnung am ersten Ende des Kanals der zweiten Speichereinrichtung zusammenfügbar ist.

Über diese sockelartigen Ausformungen können je zwei Exemplare der erfindungsgemäßen Speichereinrichtung sehr einfach miteinander gekoppelt werden. Dadurch kann die Speicherkapazität vergrößert oder ein einfaches Umfüllen der Bauelemente von einem Exemplar der Speichereinrichtung auf ein anderes Exemplar vorgenommen werden.

In einer Weiterbildung der erfindungsgemäßen Speichereinrichtung ist der Kanal über seiner gesamten Länge entlang einer kreiszylindrischen Schraubenlinie geführt. Die Ganghöhe dieser kreiszylindrischen Schraubenlinie weist zwischen den Bereichen um die Enden des Kanals im wesentlichen einen ersten Wert auf. Im Bereich der Enden des Kanals weist die Ganghöhe einen zweiten Wert auf, der gegenüber dem ersten Wert der Ganghöhe vergrößert ist. Im Bereich der Enden wird mit der vergrößerten Ganghöhe der Abschnitt der Windungen des Kanals voneinander vergrößert. Dies ermöglicht eine robuste, gegen mechanische Beschädigungen beim Zusammenfügen der sockelartigen Ausformungen unempfindliche Bauweise der erfindungsgemäßem Speichereinrichtung. Zwischen den Bereichen um die Enden des Kanals sollen jedoch dessen Windungen möglichst nah beieinander laufen, entsprechend einem möglichst geringen ersten Wert der Ganghöhe, um die Speicherkapazität der Speichereinrichtung für vorgegebene Gesamtabmessungen möglichst groß zu halten. Trotzdem wird dabei die erfindungswesentliche Form des Kanals entsprechend einer Schraubenlinie auch im Bereich der Enden des Kanals beibehalten. Damit ist auch hier eine präzise Führung der chipartigen Bauelemente gewährleistet. Dies ist ein großer Vorteil für die Kopplung der erfindungsgemäßen Speichereinrichtung, beispielsweise mit einem zweiten Exemplar derselben.

In einer anderen Ausgestaltung der erfindungsgemäßen Speichereinrichtung, bei der der Kanal über seiner gesamten Länge entlang einer zylindrischen Schraubenlinie geführt ist, weist diese Speichereinrichtung einen Aufbau mit einem zylindrischen Innenkörper und einem zylindrischen Außenkörper auf. Der Innenkörper ist mit einer äußeren Mantelfläche ausgebildet, mit der er entlang einer inneren Mantelfläche des Außenkörpers in diesen eingefügt ist. Die Mantelflächen des Innenkörpers und des Außenkörpers weisen dabei wenigstens weitgehend einander angepaßte Konturen auf.

Ein solcher Aufbau ist einfach herstellbar. Er ermöglicht auch eine sehr einfache Herstellung des Kanals, wenn dieser gemäß einer vorteilhaften Weiterbildung wenigstens weitgehend entlang der äußeren Mantelfläche des Innenkörpers in diesen Innenkörper eingeformt ist. Dabei können insbesondere die Wandungen des Kanals in drei Richtungen senkrecht zur Längserstreckung des Kanals in den Innenkörper eingeformt sein, wo hingegen die innere Mantelfläche des zylindrischen Außenkörpers eine Berandung des Kanals in der 4. Richtung senkrecht zur Längserstreckung des Kanals bildet. Ein derartiger Aufbau kann insbesondere sehr einfach durch Kunststoffspritzguß präzise, billig und in großen Stückzahlen hergestellt werden. Auch andere Fertigungsverfahren bzw. andere Werkstoffe sind ohne weiteres anwendbar.

In einer weiteren Ausgestaltung der erfindungsgemäßen Speichereinrichtung sind die erste und die zweite sockelartige Ausformung wenigstens zum wesentlichen Teil am Innenkörper angeformt. Damit weisen die sockelartigen Ausformungen und der Kanal stets eine definierte Lage zueinander auf, unabhängig von Toleranzen oder Unregelmäßigkeiten in Herstellung bzw. Handhabung der Speichereinrichtung.

Gemäß einer weiteren Fortbildung ist der Außenkörper der erfindungsgemäßen Speichereinrichtung wenigstens abschnittsweise aus einem wenigstens weitgehend durchsichtigen Werkstoff gebildet. Dies ermöglicht einen schnellen, einfachen Überblick über den Kanal, so daß Füllzustand bzw. Unregelmäßigkeiten im Betrieb mit der erfindungsgemäßen Speichereinrichtung schnell und sicher erkannt werden können. Eine vorstehend beschriebene Ausführung mit einem Innenkörper und einem Außenkörper ermöglicht außerdem einen schnellen Zugriff auf jede Stelle des Kanals.

Vorteilhaft sind die Öffnungen an den Enden des Kanals der erfindungsgemäßen Speichereinrichtung mit je einem Verschlußelement zum Verschließen des Kanals gegen Austritt von darin aufgenommenen Bauelementen ausgebildet. Vorzugsweise können diese Verschlußelemente federnd ausgebildet sein, was eine einfache Gestaltung ermöglicht. Vorteilhaft ist ferner an jeder sockelartigen Ausformung je ein Betätigungselement ausgebildet, durch welches das Verschlußelement im Bereich der komplementär gestalteten sockelartigen Ausformung einer weiteren Speichereinrichtung beim Verbinden dieser beiden Speichereinrichtungen im Sinne eines Öffnens des Kanals betätigbar ist. Ein Zusammenwirken zwischen einem solchen Betätigungselement eines ersten Exemplars der Speichereinrichtung mit einem Verschlußelement eines zweiten Exemplars der Speichereinrichtung tritt dann auf, wenn die beiden Exemplare der Speichereinrichtungen mit ihren komplementären sockelartigen Ausformungen zusammengefügt werden. Durch das Zusammenführen wird dann selbsttätig auch das Verschlußelement derart betätigt, daß die Öffnung des Kanals freigegeben wird. Hierbei treten insbesondere die Betätigungselemente der beiden Exemplare der Speichereinrichtungen im Bereich der zusammengefügten sockelartigen Ausformungen simultan zueinander mit den Verschlußelementen des jeweils anderen Exemplars der Speichereinrichtung in Wirkverbindung. Beim Koppeln der beiden Exemplare werden somit beide Verschlußelemente simultan geöffnet; beim Trennen der Exemplare der Speichereinrichtung werden durch beide Verschlußelemente die Öffnungen der Kanäle selbsttätig simultan wieder verschlossen. Ohne zusätzliche Handhabungsschritte ist somit einem Verlust von Bauelementen sicher begegnet.

Vorzugsweise sind dabei die sockelartigen Ausformungen der Speichereinrichtung im wesentlichen bajonettverschlußartig ausgebildet. Dies ermöglicht ein schnelles und unkompliziertes Zusammenfügen und Trenn von Speicherelementen.

Die erfindungsgemäße Speichereinrichtung kann in einer einfach aufgebauten und handhabungssicheren Vorrichtung mit Bauelementen befüllt und es können darin die Bauelemente aus der Speichereinrichtung auch entladen werden. Eine derartige Vorrichtung weist vorteilhaft eine erste Baugruppe zum vorzugsweise Befüllen der Speichereinrichtung mit Bauelementen auf. Mit dieser ersten Baugruppe ist die erste sockelartige Ausformung der Speichereinrichtung koppelbar. Die erste Baugruppe weist ein kanalartig ausgebildetes Zufuhrelement auf, das mit der ersten Öffnung des Kanals der Speichereinrichtung ausrichtbar ist. Uber das Zufuhrelement können dann die Bauelemente durch die erste Öffnung in den Kanal eingebracht und damit die Speichereinrichtung befüllt werden. Vorzugsweise wird für diesen Befüllvorgang das Zufuhrelement mit eine im wesentlichen linearen Vibrationsbewegung beaufschlagt. Das Zufuhrelement ist dazu vorteilhaft mit einer für eine derartige Bewegung ausgebildeten ersten Vibrationseinrichtung gekoppelt. Insbesondere wird eine solche Vibrationsbewegung in Wirkverbindung mit der Gravitation auf die zu bewegenden Bauelemente ausgeübt. Dazu kann das Zufuhrelement in Richtung auf die erste Öffnung der Speichereinrichtung geneigt angeordnet sein. Vorteilhaft wird dazu auch die Speichereinrichtung in eine Lage überführt, in der der Kanal gleichartig geneigt ist. Dies wird vorzugsweise durch Anordnung der Speichereinrichtung mit im wesentlichen senkrechter Schraubenachse erreicht. Zusätzlich kann die Speichereinrichtung mit einer im wesentlichen radialen Vibrationsbewegung beaufschlagt werden, worauf zurückgekommen wird.

Eine Vorrichtung zur Handhabung der erfindungsgemäßen Speichereinrichtung kann vorzugsweise zum Entladen der Bauelemente derart ausgestaltet sein, daß die zweite sockelartige Ausformung der Speichereinrichtung mit einer zweiten Baugruppe koppelbar ist. Diese zweite Baugruppe einer derart ausgebildeten Vorrichtung weist ein kanalartig ausgebildetes Abfuhrelement auf, welches zum Entladen der Bauelemente aus der Speichereinrichtung mit der zweiten Öffnung des Kanals der Speichereinrichtung ausrichtbar ist.

Da das Abfuhrelement einerseits und das Zufuhrelement andererseits mit zwei unterschiedlichen Öffnungen der Speichereinrichtung gekoppelt werden, können in der Vorrichtung zugleich Bauelemente in die Speichereinrichtung eingefüllt werden als auch aus ihr Entladen werden. Dadurch ist eine sehr flexible, variable Handhabung der erfindungsgemäßen Speichereinrichtung möglich.

Vorzugsweise weist eine Vorrichtung der genannten Art eine sockelartige Ausformung auf, deren Ausgestaltung zum Aufnehmen der zweiten sockelartigen Ausformung der Speichereinrichtung wenigstens weitgehend der Ausgestaltung der ersten sockelartigen Ausformung dieser Speichereinrichtung entspricht. Durch diese sockelartige Ausformung der Vorrichtung wird die zweite Öffnung des Kanals der Speichereinrichtung mit dem Abfuhrelement ausgerichtet. Die sockelartige Ausformung der Vorrichtung bewirkt somit einerseits die mechanische Stützung der Speichereinrichtung bei deren Handhabung zum Entladen der Bauelemente und stellt gleichzeitig deren einwandfreien Übergang aus dem Kanal durch die zweite Öffnung in das Abfuhrelement sicher. Durch eine einheitliche Ausbildung der sockelartigen Ausformungen können beliebige Exemplare der Speichereinrichtung mit der Vorrichtung gekoppelt und auch untereinander zusammengefügt werden. Dadurch lassen sich auf der Vorrichtung zugleich auch mehrere Exemplare der Speichereinrichtung in der Weise kaskadieren, daß ihre Kanäle nacheinander und mit dem Abfuhrelement für Bauelemente durchgängig durchlaufen werden können.

Vorteilhaft kann bei einer Vorrichtung der beschriebenen Art die sockelartige Ausformung dieser Vorrichtung mit dem Abfuhrelement gemeinsam mit einer zweiten Vibrationseinrichtung gekoppelt sein. Diese zweite Vibrationseinrichtung ist vorteilhaft im wesentlichen für eine radiale Vibrationsbewegung ausgebildet. In dieser Bauform zeit die Vorrichtung einen besonders einfachen, kompakten Aufbau.

Auch für die Förderung der Bauelemente im Abfuhrelement kann ein Zusammenwirken zwischen einer Vibrationsbewegung und dem Einfluß der Gravitation vorteilhaft eingesetzt werden.

In einer Abwandlung der Vorrichtung können für das Abfuhrelement einerseits und die sockelartige Ausformung der Vorrichtung andererseits getrennte Vibrationseinrichtungen vorgesehen werden. Für die sockelartige Ausformung wird dann eine radiale Vibrationsbewegung bevorzugt, die dieser sockelartigen Ausformung durch eine entsprechend ausgebildete Vibrationseinrichtung aufgeprägt wird. Eine weitere Vibrationseinrichtung, die im wesentlichen für eine lineare Vibrationsbewegung ausgebildet ist, wird dann getrennt mit dem Abfuhrelement verbunden. Dieser etwas aufwendigere Aufbau ermöglicht jedoch andererseits, das Abfuhrelement mit einer größeren Baulänge und einer geringeren Steigung, d.h. einem verringerten Einfluß der Gravitation, auszugestalten.

Für eine Speichereinrichtung, bei der die Öffnungen des Kanals mit je einem Verschlusselement zum Verschließen des Kanals gegen Austritt von darin aufgenommenen Bauelementen ausgebildet sind, kann die sockelartige Ausformung der Vorrichtung mit einem Betätigungselement ausgebildet sein, durch welches beim Zusammenfügen der zweiten sockelartigen Ausformung einer in genannter Weise ausgestaltenen Speichereinrichtung mit der sockelartigen Ausformung der Vorrichtung das Verschlußelement im Bereich der zweiten Öffnung des Kanals der Speichereinrichtung im Sinne eines Öffnens des Kanals betätigbar ist. Beim Koppeln der Speichereinrichtung mit der Vorrichtung wird somit selbsttätig in gleicher Weise wie beim Koppeln zweier Exemplare einer derartigen Speichereinrichtung untereinander die Öffnung des Kanals zum Durchtritt der Bauelemente in Richtung auf das Abfuhrelement freigegeben.

Eine vorteilhafte Weiterbildung der beschriebenen Vorrichtung enthält ferner eine Stopeinrichtung zum Unterbrechen der Zufuhr von Bauelementen aus dem Kanal einer gekoppelten Speichereinrichtung. Eine derartige Stopeinrichtung, die unabhängig von der Betätigung der Verschlußelemente der Speichereinrichtung wirkt, dient vorteilhaft dazu, die Zufuhr von Bauelementen bei noch mit der Vorrichtung gekoppelter Speichereinrichtung zu unterbrechen. Beispielsweise kann die Zufuhr der Bauelemente durch diese Stopeinrichtung zur Vorbereitung des Trennens der Speichereinrichtung von der Vorrichtung unterbrochen werden. Damit ist die Möglichkeit gegeben, Bauelemente aus dem Bereich der Öffnung des Kanals, vorzugsweise aus dem Bereich der zweiten Öffnung, zu entfernen, beispielsweise über ein bestimmungsgemäßes Weiterbetreiben des Abfuhrelements über eine vorgebbare Zeitspanne hinweg, bevor die Speichereinrichtung aus der Vorrichtung entfernt wird. Damit wird ein unkontrollierter Verlust von Bauelementen und eine Störung durch unkontrolliert aus der Öffnung des Kanals austretende Bauelemente vermieden.

Eine besonders einfach ausgebildete und handhabbare sowie robuste Ausgestaltung der sockelartigen Ausformungen der Vorrichtung und der Speichereinrichtung wird dadurch erreicht, daß die sockelartige Ausformung der Vorrichtung in gleicher Weise wie die sockelartigen Ausformungen der Speichereinrichtung in der Art eines Bajonettverschlusses ausgebildet sind. Eine bajonettverschlußartige Ausbildung der sockelartigen Ausformungen zeichnet sich insbesondere dadurch aus, daß in an sich üblicher Weise an diesen sockelartigen Ausformungen Bereiche vorgesehen sind, die eine kurze, schraubenartige Befestigungsbewegung vorgeben. Diese Bereiche können aber mit geringem Aufwand vorteilhaft derart ausgestaltet werden, daß sie neben einer kraftschlüssigen Kopplung auch eine sehr genaue Ausrichtung der Speichereinrichtung in der Vorrichtung und damit eine sehr präzise Ausrichtung der Öffnungen des Kanals dieser Speichereinrichtung gewährleisten. Eine präzise Positionierung der Speichereinrichtung im Betrieb trotz sehr einfacher Handhabung ist damit auf einfache Weise gewährleistet.

Ein Ausführungsbeispiel der Erfindung ist in der Zeichnung dargestellt und wird im nachfolgenden näher beschrieben. Es zeigen:
- Fig. 1: Einen Innenkörper eines Ausführungsbeispiels der erfindungsgemäßen Speichereinrichtung,
- Fig. 2: den Innenkörper nach Fig. 1, dargestellt mit einem Ausbruch,
- Fig. 3: eine Unteransicht (Ansicht A) des Innenkörpers nach Fig. 1,
- Fig. 4: eine Draufsicht (Ansicht B) des Innenkörpers nach Fig. 1,
- Fig. 5: eine Darstellung der unterschiedlichen Ganghöhen des Kanals im Innenkörper nach Fig. 1 im Bereich des ersten Endes des Kanals,
- Fig.6: eine Darstellung der unterschiedlichen Ganghöhen des Kanals im Innenkörper nach Fig. 1 im Bereich des zweiten Endes des Kanals,
- Fig. 7: eine vergrößerte Darstellung der Einzelheit C des Innenkörpers nach Fig. 1,
- Fig. 8: eine vergrößerte Darstellung der Einzelheit D des Innenkörpers nach Fig. 1,
- Fig. 9: eine vergrößerte Darstellung der Einzelheit E des Innenkörpers nach Fig. 1,
- Fig. 10: eine vergrößerte Darstellung der Einzelheit F des Innenkörpers nach Fig. 1,
- Fig. 11: eine vergrößerte Darstellung der Einzelheit G des Innenkörpers nach Fig. 1,
- Fig. 12: ein Ausführungsbeispiel für einen Außenkörper zu dem in den vorangegangenen Figuren dargestellten Ausführungsbeispiel der Speichereinrichtung,
- Fig. 13: eine Draufsicht (Ansicht H) des Außenkörpers nach Fig. 12 in vergrößerter Darstellung,
- Fig. 14: die Einzelheit I des Außenkörpers nach Fig. 12 in vergrößerter Darstellung,
- Fig. 15: die Einzelheit K des Außenkörpers nach Fig. 12 in vergrößerter Darstellung,
- Fig. 16: einen Ausschnitt des Innenteils nach Fig. 1 im Bereich des zweiten Endes des Kanals mit einem Ausführungsbeispiel für die Ausgestaltung eines Verschlußelementes,
- Fig. 17: die Einzelheit L aus Fig. 16 in vergrößerter Darstellung,
- Fig. 18: eine Schnittdarstellung des Ausführungsbeispiels des Innenkörpers nach Fig. 16 entlang der Linie M-M, um 90° im Uhrzeigersinn gedreht,
- Fig. 19: die Einzelheit N aus Fig. 18 in vergrößerter Darstellung,
- Fig. 20: die Einzelheit N aus Fig. 18 in einer gegenüber der Darstellung nach Fig. 19 veränderten Betriebssituation,
- Fig. 21: eine Darstellung der Stapelbarkeit zweier Exemplare der erfindungsgemäßen Speichereinrichtung anhand der Darstellung der Innenkörper dieser Speichereinrichtungen in einer der Fig. 16 folgenden Ausbildung,
- Fig. 22: die Einzelheit O aus Fig. 21 in vergrößerter Darstellung,
- Fig. 23: eine schematische Darstellung eines Ausführungsbeispiels einer erfindungsgemäßen Vorrichtung zum Befüllen und Entladen einer erfindungsgemäßen Speichereinrichtung gemäß dem zuvor beschriebenen Ausführungsbeispiel in Seitenansicht (Ansicht P),
- Fig. 24: eine schematische Schnittdarstellung der Vorrichtung nach Fig. 23 in Stirnansicht (Ansicht Q),
- Fig. 25: eine schematische Darstellung der Vorrichtung nach Fig. 23 in der Draufsicht (Ansicht R),
- Fig. 26: bis Fig. 37 die Handhabung des vorstehend dargestellten Ausführungsbeispiels der erfindungsgemäßen Speichereinrichtung miVorrichtung zum Entladen der Bauelemente beim Unterbrechen des Entladens und Trennen der Speichereinrichtung von der Vorrichtung, wobei die Fig. 26 bis 37 eine Schnittdarstellung entlang der Schnittebene S-S gemäß Fig. 22, um 90° im Uhrzeigersinn gedreht, wiedergeben. Insbesondere zeigen dabei

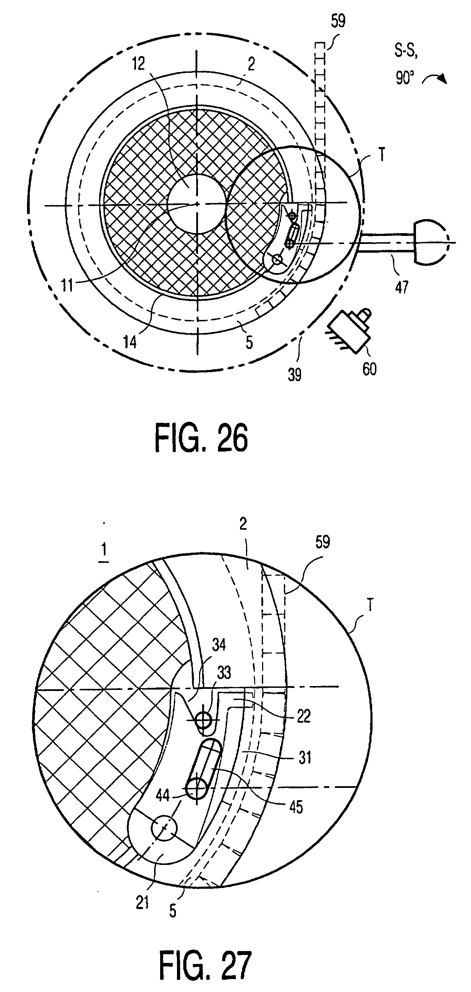

- Fig. 26: einen ersten Betriebszustand, vergleichbar einer ersten Momentaufnahme der genannten Handhabung, anhand der genannten Schnittdarstellung,
- Fig. 27: die Einzelheit T aus Fig. 26,

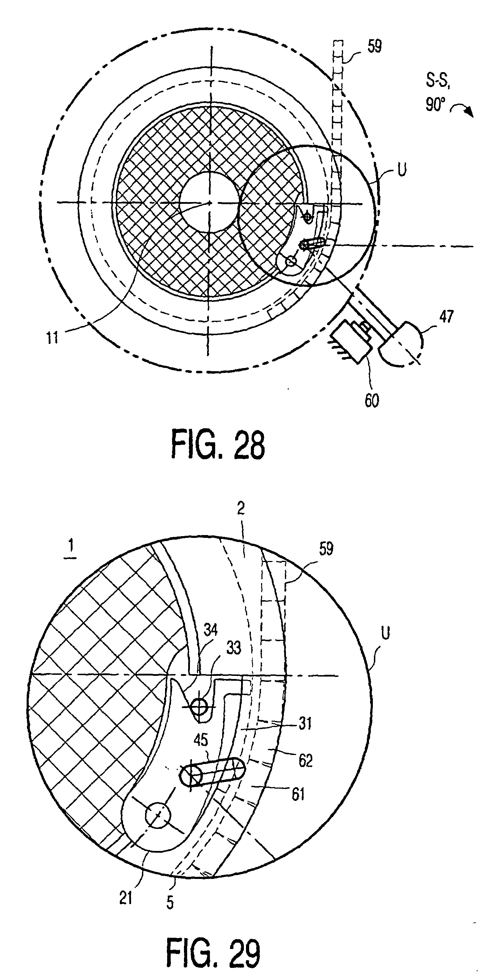

- Fig. 28: einen zweiten Betriebszustand in zu Fig. 26 vergleichbarer Darstellung,
- Fig. 29: die Einzelheit aus Fig. 28,

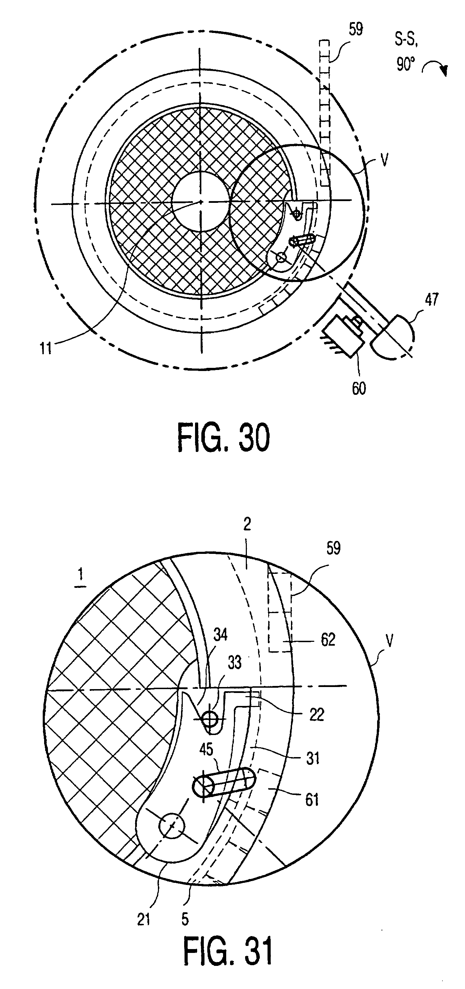

- Fig. 30: einen dritten Betriebszustand in einer Darstellung entsprechend Fig. 26,
- Fig. 31: die Einzelheit V aus Fig. 30,

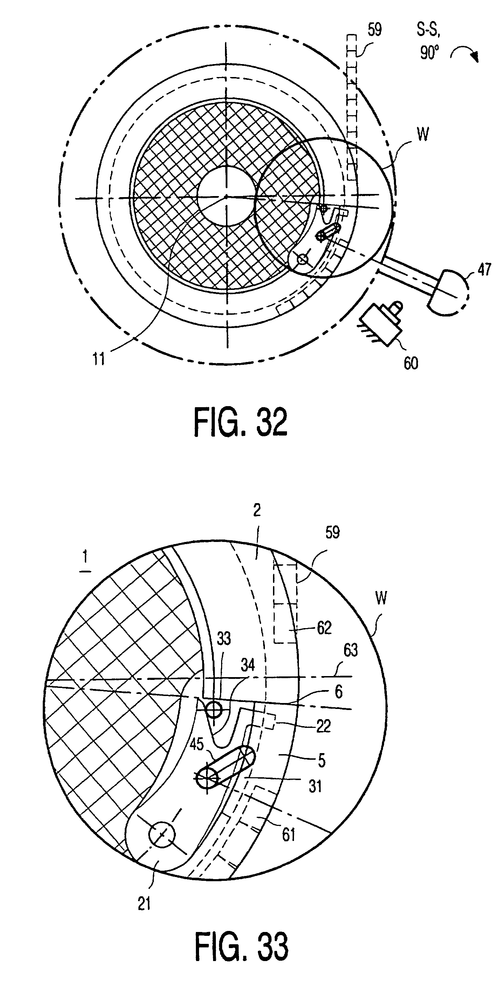

- Fig. 32: einen vierten Betriebszustand in zu Fig. 26 entsprechender Darstellung,
- Fig. 33: die Einzelheit W aus Fig. 32,

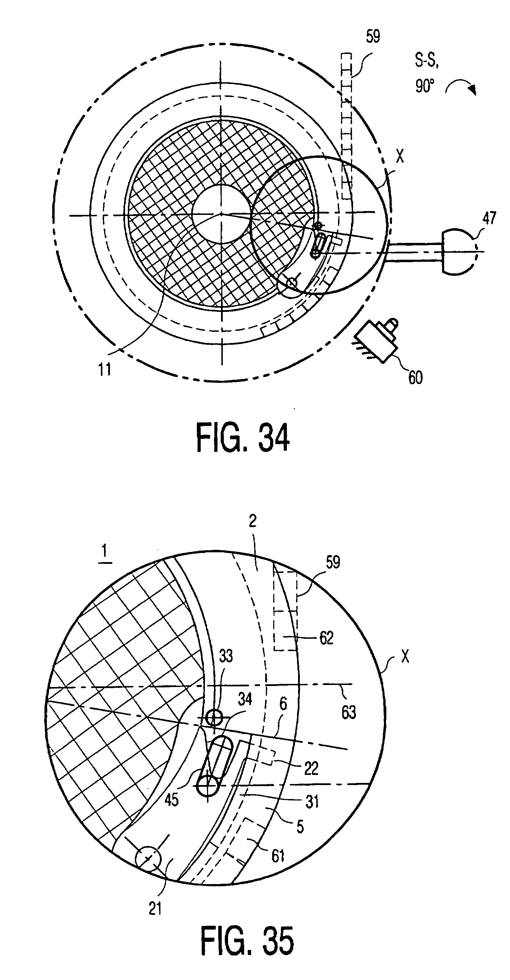

- Fig. 34: einen fünften Betriebszustand in einer der Fig. 26 entsprechenden Darstellung,
- Fig. 35: die Einzelheit X aus Fig. 34,

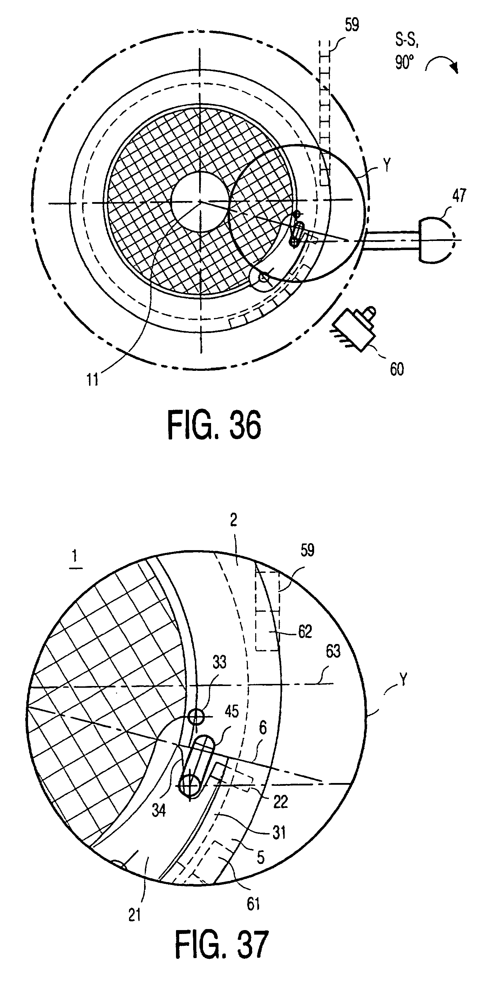

- Fig. 36: einen sechsten Betriebszustand in einer der Fig. 26 entsprechenden Darstellung und
- Fig. 37: die Einzelheit Y aus Fig. 36.

Die selben Elemente des Ausführungsbeispiels sind bei einer Darstellung in unterschiedlichen Figuren stets mit denselben Bezugszeichen versehen.

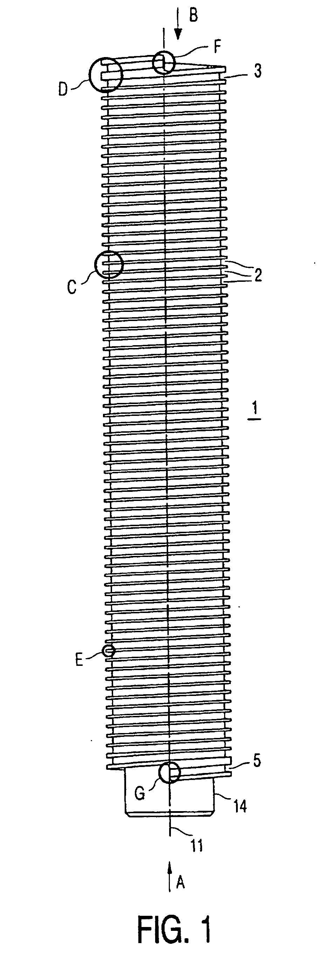

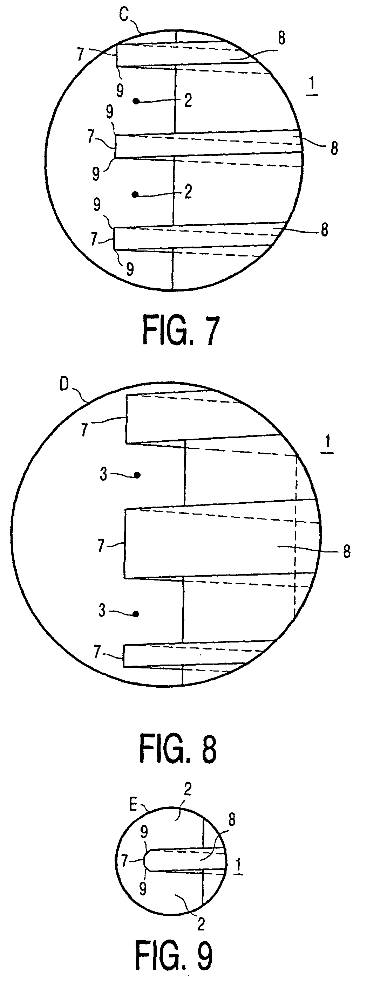

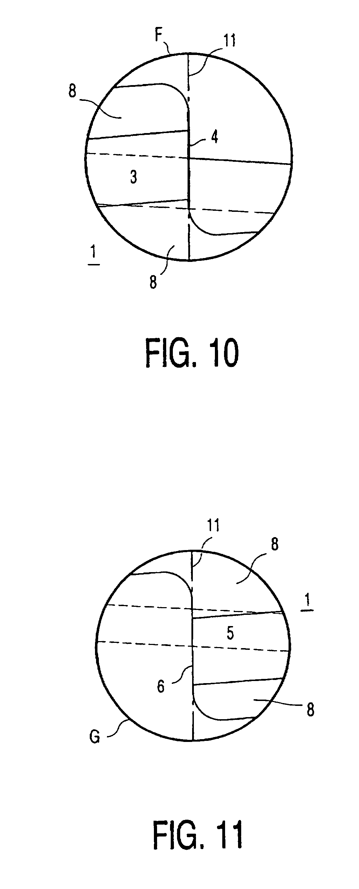

Das in den Figuren dargestellte Ausführungsbeispiel der erfindungsgemäßen Speichereinrichtung weist einen entlang einer kreiszylindrischen Schraubenlinie geführten Kanal 2 auf. Dieser ist entlang einer äußeren Mantelfläche eines kreiszylindrischen Innenkörpters 1 geführt, wie er in den Figuren 1 bis 11 dargestellt ist. Der Kanal 2 weist einen rechteckförmigen Querschnitt senkrecht zu der beschriebenen, kreiszylindrischen Schraubenlinie auf. Die Querschnittsabmessungen des Kanals 2 sind einem vorgegebenen, chipartigen, elektronischen Bauelement derart angepaßt, daß dieses in einer vorgegebenen Ausrichtung den Kanal 2 durchwandern kann, ohne darin seine Ausrichtung bezüglich der kreiszylindrischen Schraubenlinie ungewollt zu verändern oder im Kanal 2 zu verklemmen.
In dem gezeigten Ausführungsbeispiel erstreckt sich der Kanal 2 über insgesamt 72 Windungen bzw. Gänge der kreiszylindrischen Schraubenlinie. Der aus der Draufsicht (Ansicht B) des Innenkörpers 1 vorderste Gang des Kanals 2 bildet dessen erstes Ende 3, in dem der Kanal 2 über eine erste Öffnung 4 mit Bauelementen befüllt werden kann. Dieser Bereich des Kanals 2 kann daher auch als Beladebereich bezeichnet werden. Die erste Öffnung 4 am ersten Ende 3 des Kanals 2 ist als Einzelheit F beispielhaft in Fig. 10 vergrößert wiedergegeben. Eine vergrößerte Darstellung des Kanals 2 am ersten Ende 3 mit der dort vergrößerten Ganghöhe zeigt ausschnittsweise die Fig. 8 als Einzelheit D.

Der aus der Unteransicht (Ansicht A) vorderste Gang des Kanals 2 bildet dessen zweites Ende 5, weist eine ebenfalls gegenüber den übrigen Windungen des Kanals 2 vergrößerte Ganghöhe auf, die bevorzugt der Ganghöhe am ersten Ende 3 des Kanals 2 entspricht, und mündet in einer zweiten Öffnung 6. Die zweite Öffnung 6 dient bevorzugt dem Entladen der Bauelemente aus der Speichereinrichtung. Das zweite Ende 5 des Kanals 2 der Speichereinrichtung bildet daher bevorzugt einen Entnahmebereich. Fig. 11 zeigt dieses zweite Ende 5 als vergrößert dargestellte Einzelheit G aus Fig. 1.

In dem Bereich des Kanals 2, der sich zwischen dem ersten Ende 3 und dem zweiten Ende 5 erstreckt und in dem zumindest im wesentlichen die Bauelemente gespeichert werden, weist der Kanal 2 eine geringere Ganghöhe auf als an den Enden 3,5. Dies ist als Einzelheit C aus Fig. 1 in der Fig. 7 vergrößert wiedergegeben. Darüber hinaus zeigt die in Fig. 9 dargestellte Einzelheit E der Fig. 1 in vergrößerter Darstellung eine Abwandlung der Ausformung des Innenkörpers 1 im Bereich der die Wandungen des Kanals 2 bildenden Ausformungen des Werkstoffs des Innenkörpers 1. Dieser Werkstoff bildet zwischen je zwei Gängen des Kanals 2 einen Steg 8, der zumindest im wesentlichen der kreiszylindrischen Schraubenlinie folgt, entlang derer sich der Kanal 2 erstreckt. Die die kreiszylindrische, äußere Mantelfläche 7 des Innenkörpers 1 berührenden Kanten 9 dieses Steges 8 sind in der Variante gemäß Fig. 9 durch eine Fasegebrochen oder wenigstens entgratet. Dadurch wird zum einen vermieden, daß Grate an diesen Kanten 9 die Bewegung der Bauelemente im Kanal 2 beeinträchtigen.

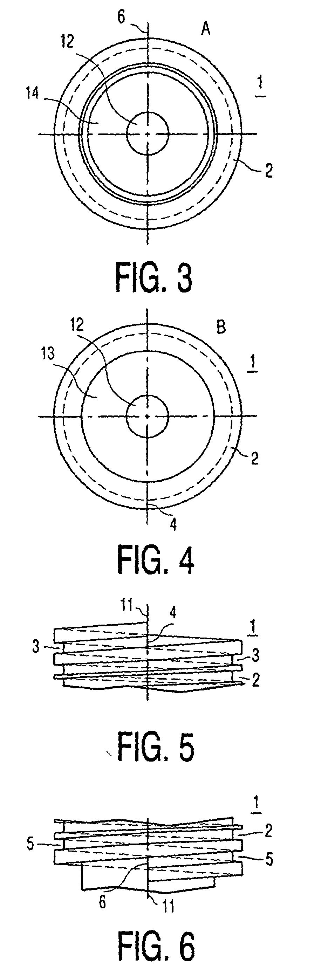

Am Übergang zwischen dem ersten Ende 3 des Kanals 2 zu dessen Speicherbereich sowie zwischen diesem Speicherbereich und dem zweiten Ende 5 des Kanals 2 wechselt entsprechend den unterschiedlichen Ganghöhen auch die Steigung der kreiszylindrischen Schraubenlinie, entlang der der Kanal 2 geführt ist. Fig. 5 zeigt diesen Übergang im Bereich des ersten Endes 3 des Kanals 2, wo hingegen in Fig. 6 der Übergang zum zweiten Ende 5 hin dargestellt ist. Im dargestellten Ausführungsbeispiel erfolgt der Wechsel der Steigung genau mit dem Übergang zur letzten Windung. Durch die vergrößerte Ganghöhe wird im Bereich der Enden 3,5 des Kanals 2 die Breite des Steges in Richtung der Schraubenachse vergrößert. Dadurch wird es möglich, den Innenkörper 1 im Bereich der Enden mechanisch stabiler auszugestalten, als dies bei unveränderter Ganghöhe und damit Stegbreite im Bereich der Enden 3,5 der Fall wäre.

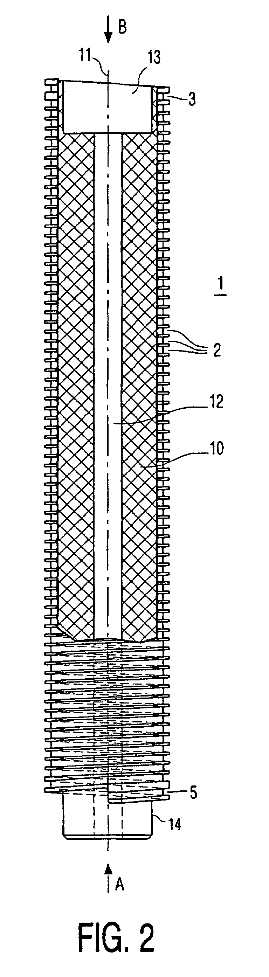

In Fig. 2 ist der kreiszylindrische Innenkörper 1 der Speichereinrichtung teilweise mit einem Ausbruch 10 dargestellt, der im wesentlichen einem teilweisen Längsschnitt entlang der Schraubenachse durch den Innenkörper 1 entspricht. In dieser Darstellung wird eine zur Schraubenachse 1 1 konzentrische, kreiszylindrische Ausnehmung (bzw. Bohrung) 12 im Werkstoff des Innenkörpers 1 sichtbar. Diese Ausnehmung 12 erstreckt sich über die gesamte Länge des Innenkörpers 1 entlang der Schraubenachse 11. Im Bereich des ersten Endes 3 des Kanals 2 erfährt die Ausnehmung 12 eine topfartige Erweiterung, die eine erste sockelartige Ausformung 13 bildet. Im Bereich des zweiten Endes 5 des Innenkörpers 1 befindet sich dagegen an diesem eine zweite sockelartige Ausformung 14, die ebenfalls zur Schraubenachse 11 konzentrisch und zur ersten sockelartigen Ausformung 13 komplementär ausgestaltet ist. In Fig. 4 ist mit der Ansicht B eine Stirnansicht der ersten sockelartigen Ausformung 13 dargestellt, wo hingegen in Fig. 3 mit Ansicht A eine Stirnansicht der zweiten sockelartigen Ausformung 14 wiedergegeben ist.

Durch die komplementäre Ausgestaltung der sockelartigen Ausformungen 13,14 zueinander können mehrere Exemplare der erfindungsgemäßen Speichereinrichtung entlang der Schraubenachse 11 miteinander in der Weise verbunden werden, daß ihre Kanäle 2 durch alle derart miteinander gekoppelten Exemplare der Speichereinrichtung in einem Stück ohne Unterbrechung von Bauelementen durchlaufen werden können. Dazu wird die erste Öffnung 4 des Kanals 2 eines dieser Exemplare für die Bauelemente durchgängig mit der zweiten Öffnung 6 des Kanals 2 eines entsprechend benachbart gekoppelten Exemplars verbunden. Eine entsprechende Verbindung wird zwischen der zweiten Öffnung 6 des Kanals 2 des erst genannten Exemplars der Speichereinrichtung und der ersten Öffnung 4 des Kanals 2 eines weiteren Exemplars der Speichereinrichtung hergestellt.

Die Figuren 10 und 11 zeigen in vergrößerter Darstellung als Einzelheiten F bzw. G die Gestaltung des Innenkörpers 1 in der Umgebung der Öffnungen 4 bzw. 6 des Kanals 2. Der Werkstoff der Stege 8 ist in der Umgebung der Öffnungen 4 bzw. 6 ausgerundet, wodurch eine verbesserte Zusammenfügbarkeit der erfindungsgemäßen Speichereinrichtungen über die sockelartigen Ausformungen 13 bzw. 14 bei gleichzeitiger Herabsetzung der mechanischen Empfindlichkeit gegen Beschädigungen erzielt wird. Außerdem ist beim dargestellten Ausführungsbeispiel die Ganghöhe der Schraubenlinie im Bereich der Enden 3,5 derart gewählt, daß die Breite des Steges 8 in Richtung der Schraubenachse 11 gemessen von dem Wert im Speicherbereich des Kanals 2 am Übergang zwischen diesem Speicherbereich und dem jeweiligen Ende 3 bzw. 5 bis zu der zugehörigen Öffnung 4 bzw. 6 des Kanals 2 auf das Doppelte sich vergrößert. Der in Richtung der Schraubenachse 11 jeweils letzte Steg als äußerste Berandung des Kanals 2 im Bereich der Enden 3 bzw. 5 kann dann bezüglich der Schraubenachse 11 dieselbe Breite aufweisen wie die Stege 8 im Inneren des Speicherbereiches des Kanals 2. Ohne vergrößerte Ganghöhe an den Enden 3 und 5 müßte diese Stegbreite gegenüber derjenigen im Speicherbereich des Kanals 2 verringert werden.

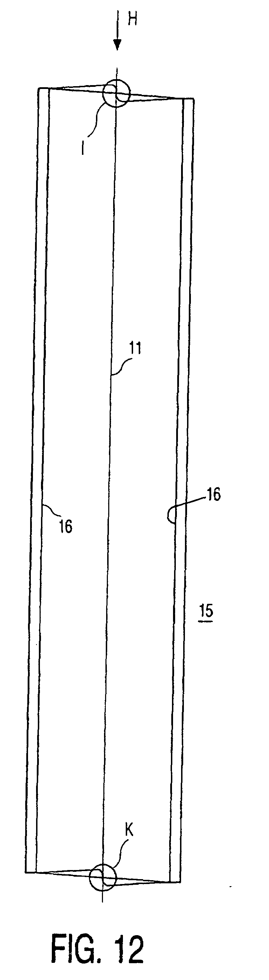

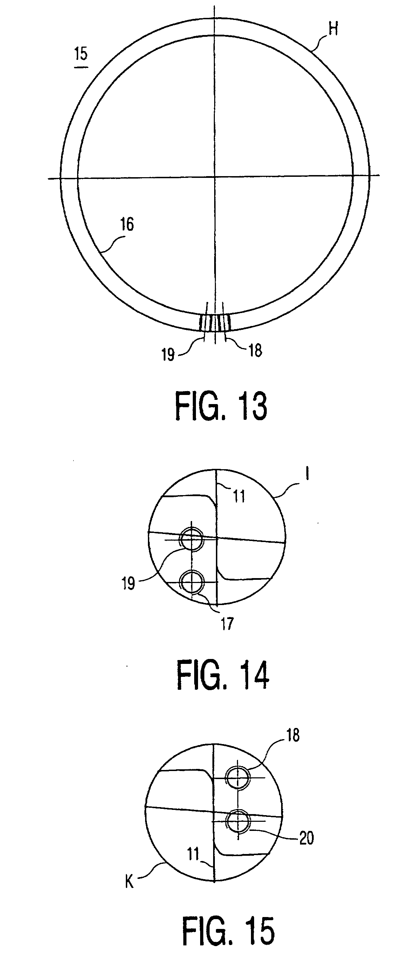

Die gemäß Fig. 9 angefasten Kanten 9 der Stege 8 erleichtern zum anderen die Montage des Innenkörpers 1 mit einem Außenkörper 15, wie er beispielhaft in den Figuren 12 bis 15 dargestellt ist, zur erfindungsgemäßen Speichereinrichtung. Der Außenkörper 15 gemäß diesem Ausführungsbeispiel ist als zur Schraubenachse 11 konzentrischer Hohlzylinder ausgebildet, dessen innere Mantelfläche 16 zumindest weitgehend die selben Abmessungen aufweist, wie die äußere Mantelfläche 7 des Innenkörpers 1, so daß zur Montage des Innenkörpers 1 mit dem Außenkörper 15 die beiden Körper entlang der Schraubenachse 11 ineinander geschoben werden können. Dabei verhindern die Fasen der Kanten 9 der Stege 8 ein Verhaken dieser Stege 8 an den Kanten des Außenkörpers 15, d.h. den stirnseitigen Berandungen der inneren Mantelfläche 16. Diese Berandungen der inneren Mantelfläche 16 sind im übrigen der Kontur des Innenkörpers 1 angepaßt, weisen also die selbe Steigung und vorzugsweise auch die Verrundungen im Bereich der Öffnungen 4 bzw. 6 auf. Diese Verrundungen sind der vergrößerten Darstellung der Einzelheiten I und K des Außenkörpers 15 in den Figuren 14 bzw. 15 wiedergegeben. Die Fig. 13 zeigt außerdem eine Ansicht H des Außenkörpers 15 in vergrößerter Darstellung. Dabei entspricht nach der Montage des Innenkörpers 1 mit dem Außenkörper 15 die Ansicht H, d.h. die Draufsicht auf den Außenkörper 15 der Blickrichtung der Ansicht B des Innenkörpers 1 gemäß Fig. 4.

Um den Füllzustand sowie den Betriebszustand der Speichereinrichtung einfacher überwachen zu können, ist der Außenkörper 15 bevorzugt aus einem durchsichtigen Werkstoff gefertigt.

In der Darstellung nach den Figuren 13 bis 15 sind im Bereich der Einzelheiten I und K je zwei Gewindebohrungen 17,19 bzw. 18,20 angeordnet. Durch Einführen von Schrauben in die Grewindebohrung 17, die bei der Montage des Innenkörpers 1 mit dem Außenkörper 15 im Bereich des ersten Endes 3 des Kanals 2 positioniert ist, sowie in die Gewindebohrung 18, die entsprechend im Bereich des zweiten Endes 5 positioniert wird, werden der Innenkörper 1 und der Außenkörper 15 miteinander arritiert. Demgegenüber sind die Gewindebohrungen 19 im Bereich des ersten Endes 3 bzw. 20 im Bereich des zweiten Endes 5 derart positioniert, daß in ihnen angebrachte Schrauben in die genannten Enden 3 bzw. 5 des Kanals 2 eindringen können. Dadurch haben diese Schrauben die Funktion je eines Verschlußelements zum Verschließen des Kanals gegen Austritt von darin aufgenommenen Bauelementen.

In den Darstellungen der Figuren 1 und 12 sind nach der Montage des Innenkörpers 1 mit dem Außenkörper 15 die Einzelheiten F und I einerseits und die Einzelheiten G und K andererseits je miteinander deckungsgleich positioniert.

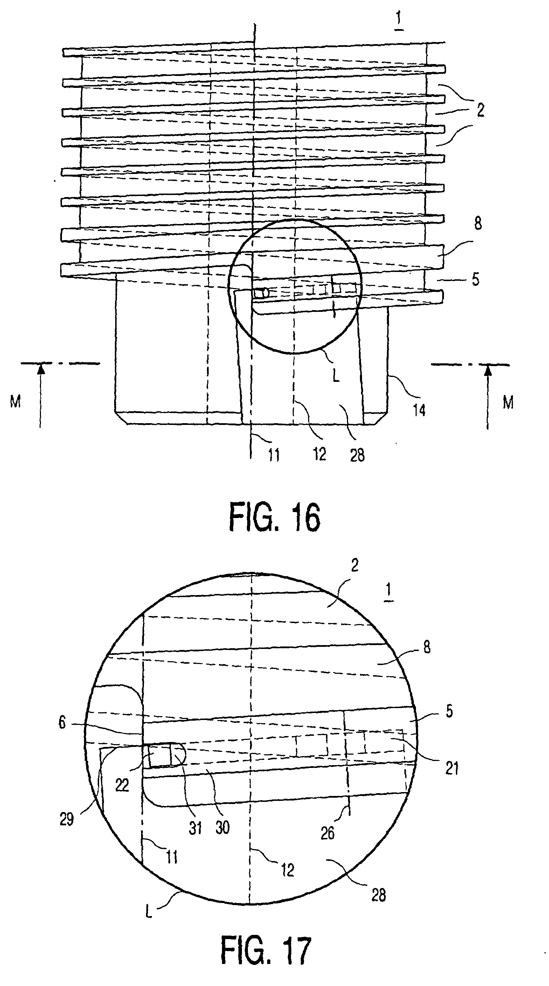

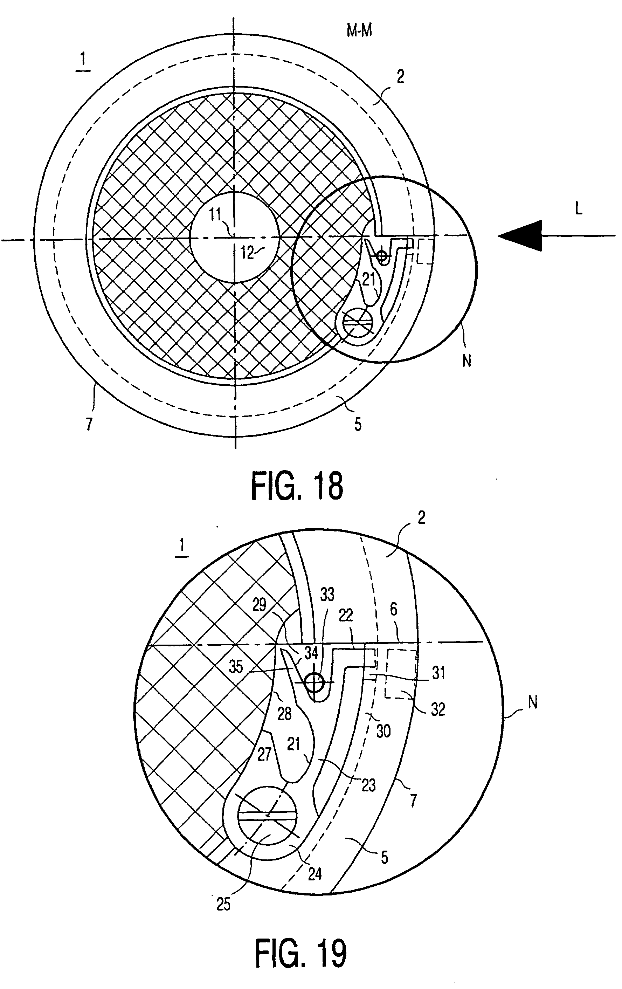

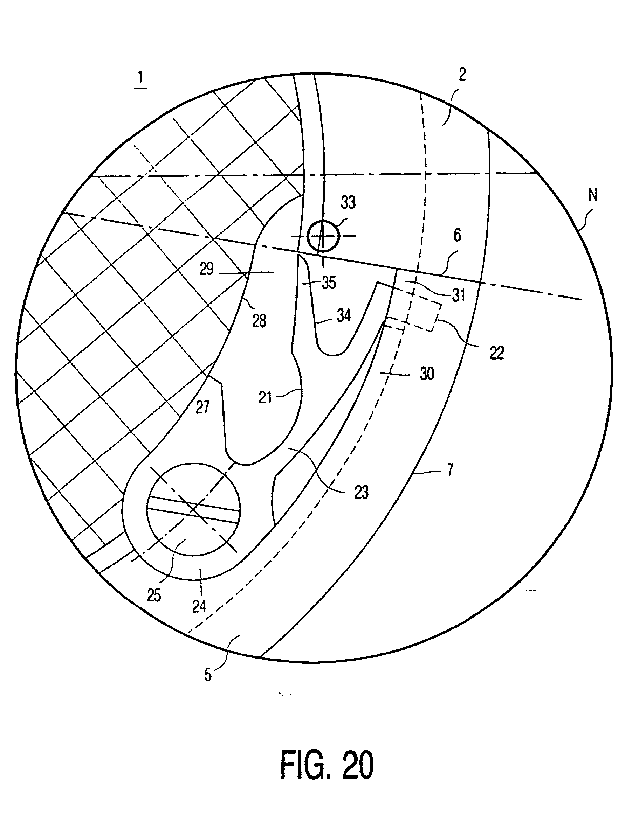

Eine einfacher bedienbare Ausführungsform eines derartigen Verschlußelements ist in den Figuren 16 bis 20 wiedergegeben. Dabei entsprechen die Blickrichtungen in den Darstellungen nach Fig. 16 und 17 der Blickrichtung der Darstellung nach Fig. 1, wohingegen Fig. 18 einen Schnitt durch die Darstellung des Innenkörpers 1 aus Fig. 16 entlang der Linie M-M, gedreht um 90° im Uhrzeigersinn, darstellt. Fig. 17 zeigt in vergrößerter Darstellung die Einzelheit L aus Fig. 16. Die Figuren 19 und 20 zeigen die Einzelheit N aus Fig. 18 in unterschiedlichen Betriebszuständen. Der zusätzlichen Orientierung halber ist in Fig. 18 mit einem Pfeil die Blickrichtung der Einzelheit L aus Fig. 17 eingetragen.

Das in den Figuren 16 bis 20 am Beispiel des zweiten Endes 5 des Kanals 2 dargestellte Verschlußelement 21 ist sperrklinkenartig ausgeführt. Der Körper dieses sperrklinkenartigen Verschlußelements 21 erstreckt sich im wesentlichen parallel zu dem Teil der Schraubenlinie, entlang dessen das zweite Ende 5 des Kanals 2 geführt ist. Dabei grenzt ein Ende des Verschlußelements 21 - bezogen auf die Ausdehnung parallel zur Schraubenlinie - unmittelbar an die zweite Öffnung 6 am zweiten Ende 5 des Kanals 2. An dieser Stelle weist der Körper des Verschlußelements 21 eine Abwinklung 22 auf, die sich im wesentlichen radial, d.h. senkrecht zur Schraubenachse 11 von dieser Schraubenachse 11 weg in das zweite Ende 5 des Kanals 2 in unmittelbarer Nachbarschaft der zweiten Öffnung 6 erstreckt. Mit dieser Abwinklung 22 kann das Verschlußelement 21 in das zweite Ende 5 des Kanals 2 eingeschwenkt werden. Dadurch wird ein Durchtritt der Bauelemente aus dem zweiten Ende 5 des Kanals 2 durch die zweite Öffnung 6 verhindert. Wird dagegen das Ende des Verschlußelements 21 mit der Abwinklung 22 einwärts in Richtung auf die Schraubenachse 11 zugeschwenkt, gibt die Abwinklung 22 das zweite Ende 5 des Kanals 2 für einen Durchtritt der Bauelemente frei. In den Figuren 18 und 19 ist dabei der Betriebszustand mit freiem Durchtritt für die Bauelemente, in Fig. 20 der Betriebszustand dargestellt, in dem der Durchtritt unterbrochen ist.

Um die beschriebene Schwenkbewegung am Ende der Abwinklung 22 zu ermöglichen, kann der Körper des Verschlußelementes 21 in seinem mittleren Abschnitt eine Verjüngung 23 aufweisen, wie dies in den Figuren 18 bis 20 dargestellt ist. Diese Verjüngung 23 ist federnd ausgebildet, wodurch die genannte Schwenkbewegung der Abwinklung 22 ermöglicht wird. Das der Abwinklung 22 gegenüberliegende Ende des Körpers des Verschlußelements 21 kann dann mit dem Innenkörper 1 der Speichereinrichtung fest verbunden werden. In der beispielhaften Ausgestaltung gemäß Fig. 16 bis 20 ist dazu das der Abwinklung 22 gegenüberliegende Ende 24 des Körpers des Verschlußelements 21 mit einer Schraube 25 mit dem Innenkörper 1 verbunden. Die Achse dieser Schraube ist in Fig. 17 mit dem Bezugszeichen 26 bezeichnet und steht senkrecht zur Schraubenlinie. Zur Abstützung des mit der Schraube 25 am Innenkörper 1 befestigten, der Abwinklung 22 gegenüberliegenden Endes 24 des Körpers des Verschlußelements 21 gegen unbeabsichtigtes Verdrehen um die Achse 26 der Schraube 25 ist an diesem Ende 24 eine Stütznase 27 angeformt. Diese Stütznase 27 stützt sich an einem Wandteil des Innenkörpers 1 ab, der einen Teil einer Mantelfläche 28 einer Ausnehmung bildet, die im Bereich der zweiten sockelartigen Ausformung 14 in den Innenkörper 1 eingesenkt ist. Als Leitkurve dieser Ausnehmung ist ein Oval vorgesehen, dessen größere Ausdehnung sich im wesentlichen entlang der Schraubenlinie erstreckt und welches eine der Krümmung der Schraubenlinie angepaßt gekrümmte Form aufweist. Die von dieser Leitkurve aufgespannte Fläche steht senkrecht zur Achse 26 der Schraube 25. Es sei besonders darauf hingewiesen, daß die Achse 26 der Schraube 25 nicht identisch ist mit der Schraubenachse 11 der Schraubenlinie, entlang der sich der Kanal 2 erstreckt.

Das Verschlußelement 21 ist mit Hilfe der Schraube 25 auf einer Bodenfläche 29 der beschriebenen Ausnehmung befestigt.

Gegenüber dem zweiten Ende 5 des Kanals 2 ist die beschriebene Ausnehmung durch ein Wandteil 30 getrennt, so daß aus dem Ende 5 keine Bauelemente in die Ausnehmung treten können. Für den Durchgriff der Abwinklung 22 des Verschlußelements 21 von der Ausnehmung in das zweite Ende 5 des Kanals 2 ist in dem Wandteil 30 eine Aussparung 31 eingeformt. Zur Veranschaulichung ist in Fig. 19 außerdem mit dem Bezugszeichen 32 ein chipartiges Bauelement angedeutet, welches sich im zweiten Ende 5 des Kanals 2 unmittelbar vor der zweiten Öffnung 6 gegenüber der Abwinklung 22 des Verschlußelements 21 befindet.

Zur Betätigung des Verschlußelements 21 dient ein Betätigungselement 33, welches in den Figuren 19 und 20 angedeutet ist und beispielsweise stiftartig geformt sein kann. Dieses Betätigungselement 33 ist nicht mit dem Innenkörper 1 verbunden, sondern kann, wie im Folgenden noch näher ausgeführt ist, gegenüber dem Innenkörper 1 und damit dem Verschlußelement 21 bewegt werden. Bei dieser Bewegung, die im übrigen auch durch kinematische Umkehr mit sich bewegendem Innenkörper 1 und feststehendem Betätigungselement 33 ausgeführt werden kann, bewegt sich das Betätigungselement 33 im wesentlichen in Richtung der Schraubenlinie, entlang der der Kanal 2 geführt ist, gegenüber dem Innenkörper 1. Dabei gleitet das Betätigungselement 33 an einer Anschlagfläche 34 eines Betätigungsfortsatzes 35 entlang. Der Betätigungsfortsatz 35 ist an den Körper des Verschlußelements 21 in einer im wesentlichen starren Verbindung mit der Abwinklung 22 angeformt. Werden im Sinne der vorgenannten Bewegung zwischen dem Betätigungselement 33 und dem Innenkörper 1 das Betätigungselement 33 und das Verschlußelement 21 aufeinander zu bewegt, gleitet der Betätigungsfortsatz 35 entlang seiner Anschlagfläche 34 am Betätigungselement 33 entlang und wird dadurch in Richtung auf die Schraubenachse 11 hin eingeschwenkt. Diese Bewegung wird durch die im wesentlichen starre Verbindung zwischen dem Betätigungsfortsatz und der Abwinklung 22 von letzterer mit ausgeführt.

Dadurch wird die Abwinklung 22 aus dem zweiten Ende 5 des Kanals 2 herausgeschwenkt und der Weg für die im Kanal 2 befindlichen Bauelemente durch die zweite Öffnung 6 aus der Speichereinrichtung heraus freigegeben. Durch Umkehr der Bewegung zwischen dem Betätigungselement 33 und dem Innenkörper 1 schwenkt die Abwinklung 22 wieder auswärts und verschließt das zweite Ende 5 des Kanals 2. Die Figuren 19 und 20 zeigen zwei Endpositionen der Bewegung zwischen dem Betätigungselement 33 und dem Innenkörper 1.

In einer Abwandlung kann der Körper des Verschlußelements 21 im wesentlichen starr ausgebildet und durch ein zusätzlich anzubringendes Federelement oder vergleichbar wirkende Einrichtungen verschwenkt und in den Endpositionen dieser Schwenkbewegung gehalten werden. Auch ist es möglich, das Verschlußelement 21 unmittelbar an den Innenkörper 1 anzuformen. Diese Abwandlung ist insbesondere für eine Herstellung des Innenkörpers 1 mit Hilfe von Kunststoff-Spritzgußtechnik vorteilhaft. Auch könnte das Verschlußelement 21 durch Steckmontage am Innenkörper 1 befestigt werden, wodurch die Schraube 25 entfallen könnte. Grundsätzlich empfiehlt sich für die Herstellung sowohl des Innenkörpers 1 als auch des Außenkörpers 15 die Anwendung der Kunststoff-Spritzgusstechnik, da auf diese Weise die erfindungsgemäße Speichereinrichtung in großer Stückzahl besonders preiswert herstellbar ist. Selbstverständlich lassen sich die Einzelteile der erfindungsgemäßen Speichereinrichtung auch aus anderen Werkstoffen, beispielsweise Metallen, und durch andere Fertigungstechniken, beispielsweise Drehen und/oder Fräsen, herstellen.

Wie im Bereich der zweiten sockelartigen Ausformung 14 des Innenkörpers 1 kann entsprechend auch im Bereich der ersten sockelartigen Ausformung 13 ein weiteres Verschlußelement angeordnet sein, für das die vorstehenden Ausführungen in vergleichbarer Weise anzuwenden sind. Damit ist der Kanal 2 an beiden Enden 3,5 verschließbar.

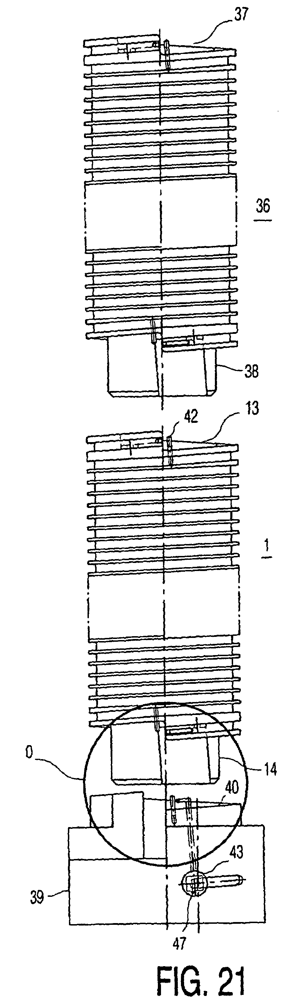

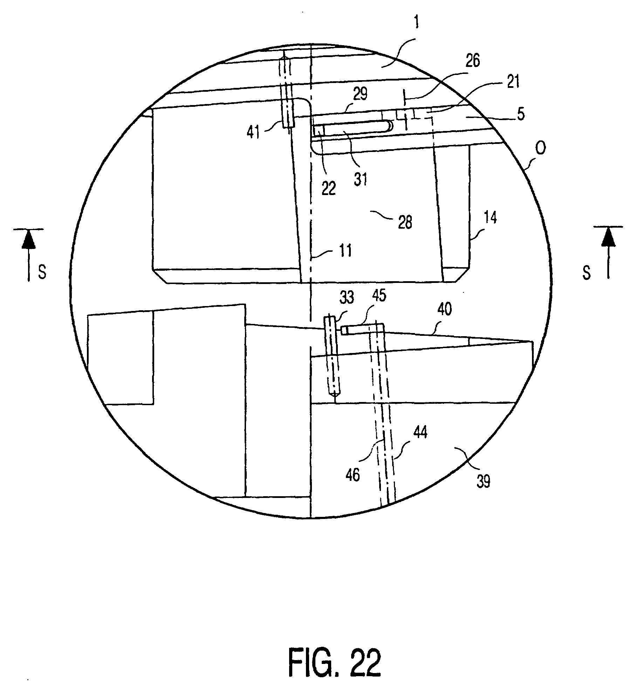

Fig. 21 zeigt schematisch die Kopplung mehrerer erfindungsgemäßer Speichereinrichtungen anhand der Ausbildung ihrer Innenkörper. Dazu wird die vorstehend beschriebene Speichereinrichtung mit ihrer ersten sockelartigen Ausformung 13 mit einer zweiten sockelartigen Ausformung 38 des Innenkörpers 36 eines zweiten Exemplars der Speichereinrichtung gekoppelt. Weitere Exemplare der Speichereinrichtung können grundsätzlich beliebig angschlossen werden, beispielsweise an eine erste sockelartige Ausformung 37 des Innenkörpers 36. In Fig. 21 ist ferner ein Adapter 39 dargestellt, der eine sockelartige Ausformung 40 aufweist, deren Ausgestaltung zum Aufnehmen der zweiten sockelartigen Ausformung 14 des Innenkörpers 1 vorgesehen ist. Dazu entspricht die sockelartige Ausformung 40 des Adapters 39 in ihrer Ausgestaltung wenigstens weitgehend der Ausgestaltung der ersten sockelartigen Ausformung 13 des Innenkörpers 1. Fig. 22 zeigt diese Ausgestaltung als vergrrößert dargestellte Einzelheit aus Fig. 21, wobei die Blickrichtung der Darstellungen der Figuren 21 und 22 derjenigen der Figuren 1 bzw. 17 entspricht. Gegenüber der Ausführung gemäß Fig. 17 ist das Verschlußelement hier im Bereich der Abwinklung 22 zusätzlich in Richtung der Schraubenachse 11 gekröpft. Ansonsten entspricht diese Version des Verschlußelements 21 zumindest im wesentlichen der bereits beschriebenen Ausführung.

Das Betätigungselement 33 ist im Bereich der sockelartigen Ausformung 40 mit dem Adapter 39 in einer Positionierung verbunden, die beim Koppeln des Innenkörpers 1 mit dem Adapter 39 eine Betätigung des Verschlußelements 21 in der beschriebenen Weise gestattet. Dabei wird der Innenkörper 1 gegenüber dem Adapter 39 um einen geringen Winkel, beispielsweise etwa 15°, um die Schraubenachse 11 gedreht. Die zweite sockelartige Ausformung 40 des Innenkörpers 1 und die sockelartige Ausformung 40 des Adapters 39 können dazu bajonettverschlußartige Rastelemente aufweisen, die in Fig. 22 nicht näher dargestellt sind. Durch diese Rastelemente kann eine feste mechanische Verriegelung zwischen der zweiten sockelartigen Ausformung 14 und der sockelartigen Ausformung 40 des Adapters 39 und damit eine feste Verbindung des Innenkörpers 1 mit dem Adapter 39 erzielt werden.

Fig. 22 zeigt außerdem ein weiteres Betätigungselement 41, welches mit dem Innenkörper 1 im Bereich der zweiten sockelartigen Ausformung 14 verbunden ist und vorzugsweise eine mit dem Betätigungselement 33 am Adapter 39 übereinstimmende Ausgestaltung aufweist. Ein dem Betätigungselement 33 des Adapters 39 entsprechendes, weiteres Betätigungselement 42 ist am Innenkörper 1 im Bereich der ersten sockelartigen Ausformung 13 angeordnet. Übereinstimmende Betätigungselemente trägt auch jedes weitere Exemplar der Speichereinrichtung, beispielsweise dasjenige mit dem Bezugszeichen 36 in Fig. 21. Beim Koppeln der beiden Innenkörper 1,36 der Exemplare der Speichereinrichtung wird dann das Verschlufselement im Bereich der ersten sockelartigen Ausformung 13 des Innenkörpers 1 von dem Betätigungselement im Bereich der zweiten sockelartigen Ausformung 38 des Innenkorpers 36 betätigt. Umgekehrt wird das Verschlußelement im Bereich der zweiten sockelartigen Ausformung 38 des Innenkörpers 36 vom Betätigungselement 42 im Bereich der ersten sockelartigen Ausformung 13 des Innenkörpers 1 betätigt. Beim Koppeln zweier Exemplare der Speichereinrichtung werden somit stets die Kanäle beider Exemplare zugleich geöffnet oder verschlossen. Entsprechend wird auch das Verschlußelement 21 im Bereich der zweiten sockelartigen Ausformung 14 des Innenkörpers 1 durch das Betätigungselement 33 betätigt, wo hingegen beim Koppeln mit dem Adapter 39 das Betätigungselement 41 im Bereich der zweiten sockelartigen Ausformung 14 wirkungslos bleibt. Der Adapter 39 ist jedoch derart ausgeformt, daß eine Behinderung der Handhabung durch das Betätigungselement 41 nicht auftritt.

Der Adapter 39 ist weiterhin mit einer Stopeinrichtung zum Unterbrechen der Zufuhr von Bauelementen aus dem Kanal 2 der Speichereinrichtung mit dem Innenkörper 1 ausgestattet. Diese Stopeinrichtung 43 umfaßt ein wellenartiges Teil 44, an dessen einem Endeim Bereich der sockelartigen Ausformung 40 des Adapters 39 ein Riegelteil 45 angeordnet ist, welches sich rechtwinklig zur Achse 46 des wellenartigen Teils 44 erstreckt. Die Achse 46 des wellenartigen Teils 44 ist vorzugsweise parallel zur Achse 26 der Schraube 25 zur Befestigung des Verschlußelements 21 am Innenkörper 1 ausgerichtet, betrachtet im gekoppelten Zustand des Innenkörpers 1 mit dem Adapter 39. Auch die Mittelachse des stiftförmigen Betätigungselements 33 des Adapters 39 ist mit der Achse 46 parallel ausgerichtet. Im verkoppelten Zustand zwischen dem Innenkörper 1 und dem Adapter 39 ragt das Ende des wellenartigen Teils 44 mit dem Riegelteil 45 in die Ausnehmung im Innenkörper 1 hinein, an deren Bodenfläche 29 das Verschlußelement 21 befestigt ist. Durch einen Hebel 47 kann das wellenartige Teil 44 um seine Achse 46 gedreht und damit das Riegelteil 45 verschwenkt werden. Die Aussparung 31 im Wandteil 30 des Innenkörpers 1 ist dazu in der Variante gemäß Figuren 21 und 22 erweitert, so daß bei dieser Schwenkbewegung des Riegelteils 45 dieses durch die Aussparung 31 in das zweite Ende 5 des Kanals 2 hineingeschwenkt werden kann. Die beschriebene Kröpfung der Abwinklung 22 des Verschlußelements 21 dient dazu, Platz für das Riegelteil 45 zu schaffen. Durch Ausschwenken des Riegelteils 45 können zwischen diesem und der inneren Mantelfläche 16 des Außenkörpers 15 Bauelemente, die sich im zweiten Ende 5 des Kanals 2 befinden, eingeklemmt und an einer weiteren Bewegung zur zweiten Öffnung 6 hin gehindert werden. Dadurch werden alle nachfolgenden Bauelemente im Kanal 2 ebenfalls am Austritt durch die zweite Öffnung 6 gehindert, während sich Bauelemente, die den Schwenkbereich des Riegelteils 45 bereits verlassen haben, weiterhin ungehindert durch die zweite Öffnung 6 aus der Speichereinrichtung austreten können. Ist auf diese Weise das zweite Ende 5 des Kanals 2 von Bauelementen geleert, insbesondere im Bereich der Abwinklung 22, kann durch Lösen der Kopplung zwischen dem Innenkörper 1 und dem Adapter 39 das Verschlußelement 21 mit seiner Abwinklung 22 in das zweite Ende 5 des Kanals 2 eingeschwenkt und somit die Speichereinrichtung verschlossen werden. Anschließend kann das Riegelteil 45 zurückgeschwenkt werden und die eingeklemmten Bauelemente befreien.

Ein Ausführungsbeispiel für diesen Betätigungsablauf ist untenstehend beschrieben.

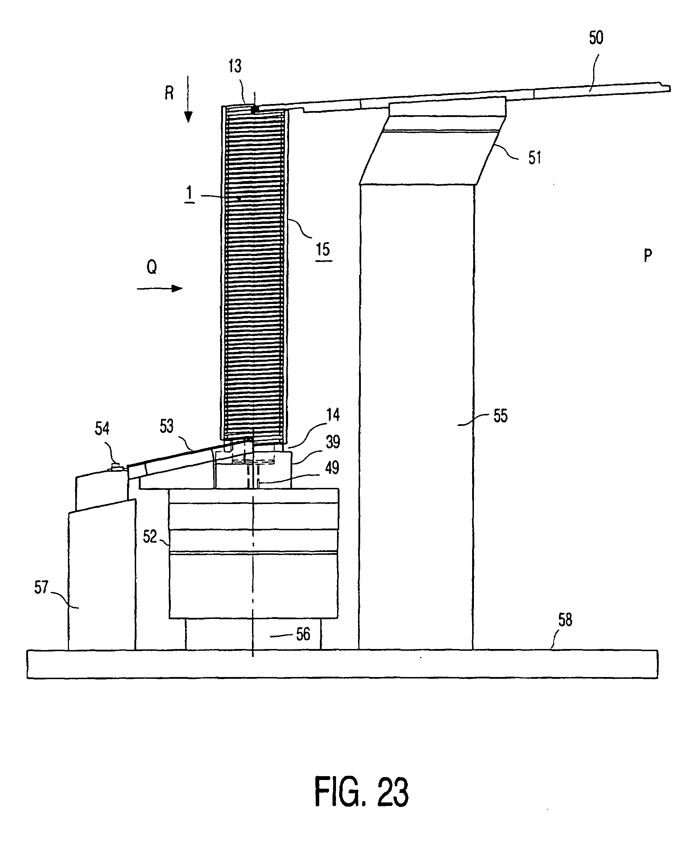

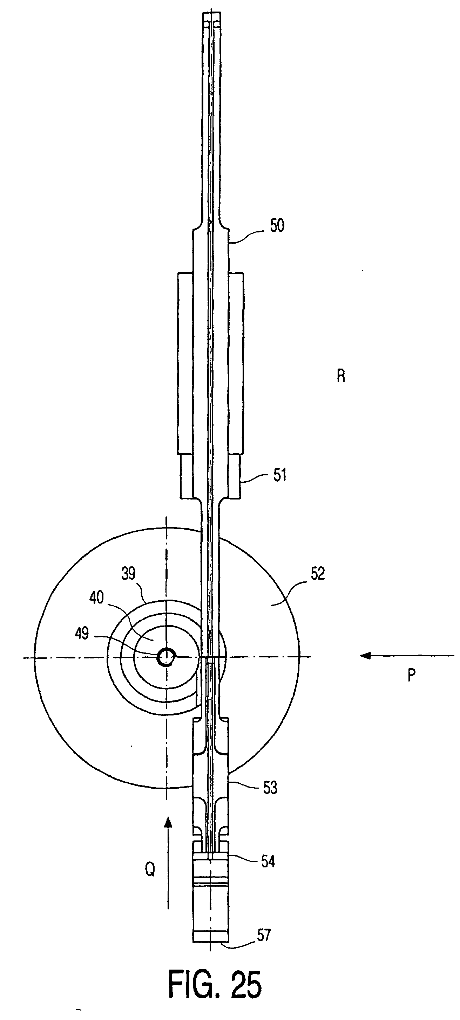

In den drei Ansichten der Figuren 23 bis 25 ist ein Ausführungsbeispiel für eine Vorrichtung mit einer beschriebenen Speichereinrichtung dargestellt. Diese Vorrichtung enthält den vorstehend beschriebenen Adapter 39, über den die Speichereinrichtung mit der Vorrichtung gekoppelt ist. Zur Erhöhung der Festigkeit dieser Kopplung insbesondere gegenüber Vibrationsbewegungen zur Förderung der Bauelemente in der Speichereinrichtung ist ein Bolzen von der ersten sockelartigen Ausnehmung 13 her durch die kreiszylindrische Ausnehmung 12 konzentrisch zur Schraubenachse 11 bis in eine entsprechend angeordnete Gewindebohrung im Adapter 39 geführt und dort verschraubt. Mit einer bajonettverschlußartigen Ausbildung der sockelartigen Ausformungen und entsprechend mechanisch fester Arretierung der Kopplung kann auf den Bolzen 48 und die Gewindebohrung 49 im Adapter 39 verzichtet werden.

Die Vorrichtung gemäß Fig. 23 bis 25 gliedert sich in eine erste Baugruppe zum Befüllen der Speichereinrichtung 1,15 mit Bauelementen, und eine zweite Baugruppe zum Entladen der Bauelemente aus der Speichereinrichtung 1,15. Die erste Baugruppe umfaßt ein kanalartig ausgebildetes Zufuhrelement 50, welches mit der ersten Öffnung 4 des Kanals 2 der Speichereinrichtung 1,15 zum Befüllen mit Bauelementen ausgerichtet werden kann. Dieses Zufuhrelement 50 ist auf einer ersten Vibrationseinrichtung 51 befestigt, die im wesentlichen für eine lineare Vibrationsbewegung ausgebildet ist, durch die die Bauelemente entlang der Längsausdehnung des Zufuhrelements 50 auf die Speichereinrichtung 1,15 zu bewegt werden. Mit dem Zufuhrelement 50 können weitere Vorrichtungen zur Fertigung bzw. Konfektionierung von Bauelementen verbunden sein, die jedoch nicht dargestellt sind.

Die erste Baugruppe umfaßt weiterhin den Adapter 39, der auf einer zweiten Vibrationseinrichtung 52 montiert ist, die im wesentlichen für eine radiale Vibrationsbewegung ausgebildet ist. Durch diese zweite Vibrationseinrichtung 52 werden im Zusammenwirken mit der Gravitation die Bauelemente in der Speichereinrichtung 1,15 entlang des Kanals 2 von dem ersten Ende 3 zum zweiten Ende 5 gefördert. Durch Zufuhr einer entsprechenden Anzahl von Bauelementen über das Zufuhrelement 50 kann so durch die Bauteile der ersten Baugruppe die Speichereinrichtung 1,15 befüllt werden.

Adapter 39 und die zweite Vibrationseinrichtung 52 sind zugleich auch Bestandteile einer zweiten Baugruppe, durch die die Bauelemente aus der Speichereinrichtung 1,15 entladen werden können. Dazu enthält die zweite Baugruppe weiterhin ein kanalartig ausgebildetes Abfuhrelement 53, welches mit der zweiten Öffnung 6 des Kanals 2 der Speichereinrichtung 1,15 ausgerichtet werden kann. Über die zweite Öffnung 6 werden dann die Bauelemente der Speichereinrichtung 1,15 entnommen und beispielsweise einer Bestückungsmaschine zugeführt. Diese geschieht beispielsweise über eine feststehende, d.h. nicht mit einer der Vibrationseinrichtungen verbundene Auffangvorrichtung 54, die mit dem kanalartig ausgebildeten Abfuhrelement ausgerichtet werden kann.

In dem Ausführungsbeispiel der Vorrichtung nach Fig. 23 bis 25, welches nur schematisch dargestellt ist, wurde auf die Darstellung der Verschlußelemente an der Speichereinrichtung 1,15 sowie von Betätigungselementen am Adapter 39 sowie im Bereich der ersten sockelartigen Ausformung 13 der Übersichtlichkeit halber verzichtet. Selbstverständlich kann an der Koppelstelle zwischen dem Zufuhrelement 50 und dem ersten Ende 3 des Kanals 2 ein entsprechend der vorstehenden Beschreibung ausgebildetes Betätigungselement angeordnet sein, beispielsweise im Zusammenhang mit einem Bauteil, welches entsprechend der zweiten sockelartigen Ausformung 14 geformt ist und zum Befüllen in die erste sockelartige Ausformung 13 eingesetzt wird.

Bei dem gezeigten Ausführungsbeispiel der Vorrichtung ist ferner das Abfuhrelement 53 gemeinsam mit dem Adapter 39 auf der zweiten Vibrationseinrichtung 52 angeordnet. In einer Abwandlung dieser Anordnung kann das Abfuhrelement 53 auch mit einer weiteren Virbrationseinrichtung verbunden sein, die zweckmäßigerweise wieder für eine im wesentlichen lineare Vibrationsbewegung eingerichtet ist. Diese etwas aufwendigere Ausgestaltung der Vorrichtung birgt den Vorteil, daß die Bauelemente im Abfuhrelement 53 leichter gefördert werden können und somit die Neigung des Abfuhrelements 53 zwischen der zweiten Öffnung 6 und der Auffangvorrichtung 54 geringer ausgelegt werden kann, da zur Förderung der Bauelemente der Einfluß der Gravitation nicht so stark ausgenutzt werden muß. Beispielsweise kann dadurch das Abfuhrelement 53 eine größere Länge aufweisen.

Neben der Kombination aus Vibrationsbewegungen und Gravitation können auch andere Antriebsmechanismen zur Förderung der Bauelemente wahlweise eingesetzt werden, beispielsweise Druckluft. Bei der erfindungsgemäßen Speichereinrichtung besteht hierin eine große Auswahlmöglichkeit ohne die einschränkende Notwenigkeit einer bestimmten Kombination unterschiedlicher Fördermechanismen.

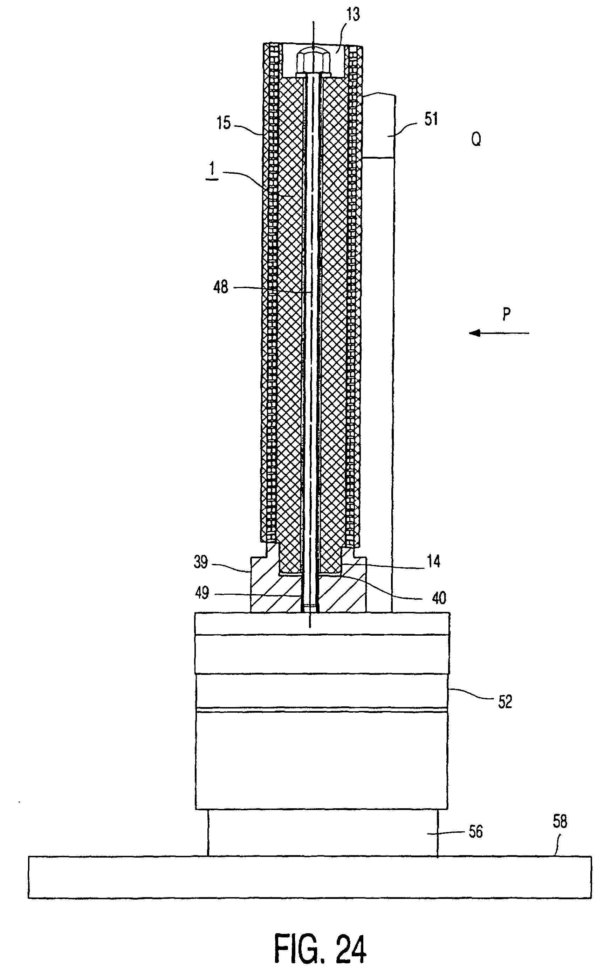

Der Vollständigkeit halber sei angegeben, daß in dem beschriebenen Ausführungsbeispiel der Vorrichtung zum Befüllen und Entladen der Speichereinrichtung 1,15 die Vibrationseinrichtungen 51,52 sowie die Auffangvorrichtung 54 über entsprechend angepaßte Sockelelemente 55,56 bzw. 57 auf einer gemeinsamen Grudplatte 58 befestigt sind. Die Fig. 24 zeigt in der Ansicht Q einen Längsschnitt durch die Speichereinrichtung 1,15 und den Adapter 39, wobei das Abfuhrelement 53, die Auffangvorrichtung 54 und das Sockelelement 57 vollständig weggelassen wurden sowie von der ersten Vibrationseinrichtung 51 nur der untere Teil als Ausbruch unter Weglassen des Zufuhrelements 50 wiedergegeben ist. Im übrigen wurde in Fig. 23 bis 25 auch auf die Darstellung der Stopeinrichtung 43 verzichtet. Adapter 39, Zufuhrelement 50 und Abfuhrelement 53 sind zueinander derartig angeordnet, daß die Ausrichtung der Öffnungen 4,6 der Speichereinrichtung 1,15 allein durch Einsetzen mit der zweiten sockelartigen Ausformung 14 in den Adapter 39 bewirkt wird.

Für die Darstellung der sechs Betriebszustände während der Handhabung der erfindungsgemäßen Speichereinrichtung 1,15 beim Unterbrechen des Entladens und Trennen der Speichereinrichtung von der vorstehend beschriebenen Vorrichtung ist für das Verschlusselement 21 eine vereinfachte Darstellung gewählt worden.

Im ersten Betriebszustand gemäß Fig. 26 und 27 ist das Verschlußelement in Richtung auf die Schraubenachse 11 eingeschwenkt. Eine Reihe 59 chipartiger elektronischer Bauelemente wird aus dem Kanal 2 über dessen zweites Ende 5 und durch die zweite Öffnung 6 der Speichereinrichtung 1,15 entnommen, wobei die zweite Vibrationseinrichtung 52 in Betrieb ist. Das Betätigungselement 33 des Adapters 39 greift diesem ersten Betriebszustand weit in die Anschlagfläche 34 des Betätigungsfortsatzes 35 des Verschlußelements 21 ein. Das Riegelteil 45 der Stopeinrichtung 43 ist in Richtung auf die Schraubenachse 11 des Innenkörüers 1 eingeschwenkt, wobei der Hebel 47 sich in der Darstellung der Fig. 26, 27 in waagerechter Stellung befindet.

Im zweiten Betriebszustand gemäß Fig. 28 und 29 ist bei unverändert betriebener zweiter Vibrationseinrichtung 52 das Riegelteil 45 der Stopeinrichtung 43 mit Hilfe des Hebels 47 bis in eine Position verschwenkt, in der das Riegelteil 45 durch die Aussparung 31 hindurch in das zweite Ende 5 des Kanals 2 eingreift und hier in der Reihe 59 der Bauelemente ein Bauelement 61 festklemmt. Dadurch werden außer diesem Bauelement 61 auch alle ihm im Kanal 2 nachfolgenden Bauelemente am weiteren Austritt aus der Speichereinrichtung 1,15 gehindert. Ein in der Reihe 59 vor dem Bauelement 61 liegendes Bauelement 62 wird dagegen in seiner weiteren Bewegung nicht behindert.

In diesem Betriebszustand wird die zweite Vibrationseinrichtung 52 so lange weiter betrieben, bis sich der unbehinderte Teil der Reihe 59 der Bauelemente mit dem Bauelement 62 als letztem durch die Öffnung 6 aus dem zweiten Ende 5 des Kanals 2 heraus bewegt hat.

Dieser Zustand ist in den Fig. 30 und 31 wiedergegeben. Die zweite Vibrationseinrichtung 52 wird nun abgeschaltet. Zwischen den Bauelementen 61 und 62 ist in der Reihe 59 eine Lücke entstanden.

Zwischen dem zweiten Betriebszustand gemäß Fig. 28 und 29 einerseits und dem dritten Betriebszustand gemäß den Fig. 30 und 31 andererseits liegt eine Zeitspanne, während der das letzte Bauelement 62 vor der in der Reihe 59 entstehenden Lücke vollständig aus der Speichereinrichtung 1,15 abgewandert sein muß. Zum automatischen Einhalten dieser Zeitspanne kann eine Zeitschaltung eingesetzt werden, die beim Verschwenken des Hebels 47 in die Lage gemäß dem zweiten Betriebszustand über einen Schalter 60 in Tätigkeit gesetzt wird und die zweite Vibrationseinrichtung 52 vom Zeitpunkt dieser Betätigung an um die genannte Zeitspanne nachlaufen läßt.

Im vierten Betriebszustand gemäß Fig. 32 und 33 ist begonnen worden, nach Abschalten der zweiten Vibrationseinrichtung 52 die Speichereinrichtung 1,15 und damit die zweite sockeartige Ausformung 14 gegenüber dem Adapter 39 mit dem Betätigungselement 33 um die Schraubenachse 11 zu verdrehen. In der gewählten Darstellung erfolgt diese Verdrehung im Uhrzeigersinn. Die ursprüngliche Lage der Speichereinrichtung 1,15 im ersten Betriebszustand ist durch eine Linie 63 markiert.

Im vierten Betriebszustand gemäß Fig. 32 und 33 ist außerdem der Hebel 47 um einen Winkel zurückgeschwenkt worden, durch den das Riegelteil 45 aus dem zweiten Ende 5 des Kanals 2 verschwenkt wird und das zuvor eingeklemmte Bauelement 61 wieder freigibt. Durch das Verdrehen der gesamten Speichereinrichtung 1,15 um die Schraubenachse 11 wird jedoch auch das Betätigungselement 33 entlang der Anschlagfläche 34 des Betätigungsfortsatzes 35 des Verschlußelements 21 um eine Strecke auswärts gleiten, durch die ein Ausschwenken des Verschlußelements 21 mit der Abwinklung 22 in das zweite Ende 5 des Kanals 2 hinein bewirkt wird. Dieses Ausschwenken genügt, um einen Austritt des bisher festgeklemmten Bauelements 61 durch die Öffnung 6 zu verhindern. Außerdem wird der Schalter 60 wieder freigegeben.

Im fünften Betriebszustand gemäß Fig. 34 und 35 ist der Hebel 47 wieder in seine Ausgangslage zurückgeschwenkt worden. Damit nimmt auch das Riegelteil 45 wieder seine Ausgangsposition ein. Dagegen ist die Speichereinrichtung 1,15 im Sinne der im vierten Betriebszustand eingeleiteten Drehbewegung weiterbewegt worden, wodurch das Verschlußelement 21 mit seiner Abwinklung 22 weiter in das zweite Ende 5 des Kanals 2 eingeschwenkt ist. Im sechsten Betriebszustand gemäß Fig. 36 und 37 ist die Drehbewegung der Speichereinrichtung 1,15 um die Schraubenachse 11 vollständig ausgeführt worden. Die Speichereinrichtung 1,15 kann nun aus dem Adapter 39 entfernt werden. Das Verschlußelement 21 ist vollständig ausgeschwenkt und das Betätigungselement 33 aus dem Bereich der Anschlagfläche 34 entfernt.

Mit der erfindungsgemäßen Speichereinrichtung können somit chipartige elektronische Bauelemente, aber auch mechanisch ähnliche Produkte anderer Art unter Beibehaltung ihrer Ausrichtung und Reihenfolge aufgenommen, verlustsicher gespeichert und wieder abgegeben werden. Die erfindungsgemäße Speichereinrichtung dient bei Transport und Lagerung als Behälter zum Schutz der Produkte. Teilbefüllung der Speichereinrichtung mit Produkten und Teilentnahme von Produkten aus der Speichereinrichtung sind ohne Produktverlust möglich. Die Speichereinrichtung ist außerdem wieder verwendbar. Insbesondere durch einen durchsichtig ausgebildeten Außenkörper sind Art und Menge des Inhalts der Speichereinrichtung leicht erkennbar. Die Speichereinrichtung wirkt in der Art eines FIFO-Speichers. Durch entsprechende Auswahl der Werkstoffe für den Innenkörper und den Außenkörper kann nicht nur ein mechanischer, sondern auch ein elektrostatischer und ggf. magnetischer Schutz der gespeicherten Produkte erhalten werden. Der beidseitige Verschluß des Kanals durch Verschlußelemente dient nicht nur dem Schutz vor Verlust von Produkten, sondern auch dem Schutz vor Verschmutzungen. Die äußere Oberfläche insbesondere des Außenkörpers ermöglicht in einfacher Weise die Anbringung von die gespeicherten Produkte und ihren Einsatz kennzeichnenden Markierungen. Durch eine einfache Handhabung sind bei der erfindungsgemäßen Speichereinrichtung Unterbrechungen des Belade- und des Entnahmevorgangs ohne Produktverlust schnell und mit geringstem Handhabungsaufwand möglich. Insbesondere werden gegenüber einer Aufreihung von Bauteilen auf Bändern umständliche Einfädel- und Aufwickelvorgänge eingespart. Durch die Gestaltung, die der Führung des Kanals entlang einer Schraubenlinie folgt, wird eine hohe mechanische Stabilität erreicht.

## Patentansprüche

1. Speichereinrichtung mit einem Kanal (2) zur Aufnahme von Bauelementen in vorgebbarer Reihenfolge und Ausrichtung, in welcher der Kanal (2) zwischen einem ersten (3) und einem zweiten Ende (5) wenigstens weitgehend entlang einer Schraubenlinie um einen Innenkörper (1) geführt ist und am ersten Ende (3) durch eine erste Öffnung (4) mit der äußeren Umgebung der Speichereinrichtung in Verbindung steht, wobei diese erste Öffnung (4) am ersten Ende (3) des Kanals (2) zum Befüllen der Speichereinrichtung mit Bauelementen vorgesehen ist, **dadurch gekennzeichnet, daß** der Kanal (2) zur Aufnahme chipartiger, elektronischer Bauelemente (32) eingerichtet und eine zweite Öffnung (6) am zweiten Ende (5) des Kanals (2) zum Entladen der Bauelemente(32) aus der Speichereinrichtung vorgesehen ist, sowie **gekennzeichnet durch** eine erste, sockelartige im Innenkörper (1) gebildete Ausformung (13) im Bereich des ersten Endes (3) des Kanals (2) und eine zweite, sockelartige im Innenkörper (1) gebildete Ausformung (14) im Bereich des zweiten Endes (5) des Kanals (2), welche sockelartigen Ausformungen (13, 14) zueinander komplementär gestaltet sind und wobei die zweite, sockelartige Ausformung (38) eines ersten Exemplars der Speichereinrichtung mit der ersten, sockelartigen Ausformung (13) eines zweiten Exemplars der Speichereinrichtung zum für die Bauelemente (32) durchgängigen Verbinden der zweiten Öffnung (6) am zweiten Ende (5) des Kanals (2) der ersten Speichereinrichtung mit der ersten Öffnung (4) am ersten Ende (3) des Kanals (2) der zweiten Speichereinrichtung zusammenfügbar ist.

2. Speichereinrichtung nach Anspruch 1,
**dadurch gekennzeichnet, daß** der Kanal (2) im wesentlichen entlang einer zylindrischen Schraubenlinie geführt ist.

3. Speichereinrichtung nach Anspruch 1,
**dadurch gekennzeichnet, daß** der Kanal (2) im wesentlichen entlang einer kreiszylindrischen Schraubenlinie geführt ist.

4. Speichereinrichtung nach Anspruch 1,
**dadurch gekennzeichnet, daß** der Kanal (2) über seiner gesamten Länge entlang einer kreiszylindrischen Schraubenlinie geführt ist, deren Ganghöhe zwischen den Bereichen um die Enden (3, 5) des Kanals (2) im wesentlichen einen ersten Wert aufweist und deren Ganghöhe im Bereich der Enden (3, 5) des Kanals (2) einen gegenüber diesem ersten Wert vergrößerten zweiten Wert aufweist.

5. Speichereinrichtung nach einem der Ansprüche 1 bis 4, bei der der Kanal (2) über seiner gesamten Länge entlang einer zylindrischen Schraubenlinie geführt ist,
**gekennzeichnet durch** einen Aufbau mit einem zylindrischen Innenkörper (1; 36), der mit einer äußeren Mantelfläche (7) entlang einer inneren Mantelfläche (16) eines zylindrischen Außenkörpers (15) in diesen eingefügt ist, wobei die Mantelflächen (7, 16) wenigstens weitgehend einander angepaßte Konturen aufweisen.

6. Speichereinrichtung nach Anspruch 5,
**dadurch gekennzeichnet, daß** der Kanal (2) wenigstens weitgehend entlang der äußeren Mantelfläche (7) in den Innenkörper (1; 36) eingeformt ist.

7. Speichereinrichtung nach Anspruch 5 oder 6,
**dadurch gekennzeichnet, daß** die erste und die zweite sockelartige Ausformung (13, 14 bzw. 37, 38) der Speichereinrichtung wenigstens zum wesentlichen Teil am Innenkörper (1 bzw. 36) angeformt sind.

8. Speichereinrichtung nach Anspruch 5, 6 oder 7,
**dadurch gekennzeichnet, daß** der Außenkörper (15) wenigstens abschnittsweise aus einem wenigstens weitgehend durchsichtigen Werkstoff gebildet ist.

9. Speichereinrichtung nach einem der vorhergehenden Ansprüche,
**dadurch gekennzeichnet, daß** die Öffnungen (4, 6) mit je einem Verschlußelement(21) zum Verschließen des Kanals (2) gegen Austritt von darin aufgenommenen Bauelementen (32) ausgebildet sind.

10. Speichereinrichtung nach Anspruch 9,
**dadurch gekennzeichnet, daß** die Verschlusselemente (21) federnd ausgebildet sind.

11. Speichereinrichtung nach Anspruch 9 oder 10,
**gekennzeichnet durch** je ein an jeder sockelartigen Ausformung (13, 14; 37, 38) ausgebildetes Betätigungselement (41, 42), **durch** welches das Verschlußelement (21) im Bereich der komplementär gestalteten sockelartigen Ausformung (38 bzw. 37; 14 bzw. 13) einer weiteren Speichereinrichtung beim Verbinden dieser beiden Speichereinrichtungen im Sinne eines Öffnens des Kanals (2) betätigbar ist.

12. Speichereinrichtung nach einem der vorhergehenden Ansprüche,
**gekennzeichnet durch** eine im wesentlichen bajonettverschlußartige Ausbildung der ersten und zweiten sockelartigen Ausformung (13, 14; 37, 38).

13. Vorrichtung mit einer Speichereinrichtung nach Anspruch 1,
in der die erste sockelartige Ausformung (13; 37) der Speichereinrichtung mit einer ersten Baugruppe zum vorzugsweise Befüllen der Speichereinrichtung mit Bauelementen (32) koppelbar ist, welche erste Baugruppe ein kanalartig ausgebildetes Zufuhrelement (50) aufweist, das mit der ersten Öffnung(4) des Kanals (2) der Speichereinrichtung ausrichtbar ist.

14. Vorrichtung nach Anspruch 13,
**dadurch gekennzeichnet, daß** das Zufuhrelement (50) mit einer im wesentlichen für eine lineare Vibrationsbewegung ausgebildeten ersten Vibrationseinrichtung(51) gekoppelt ist.

15. Vorrichtung mit einer Speichereinrichtung nach Anspruch 1,
in der die zweite sockelartige Ausformung (14; 38) mit einer zweiten Baugruppe zum vorzugsweise Entladen der Bauelemente (32) koppelbar ist, welche zweite Baugruppe ein kanalartig ausgebildetes Abfuhrelement (53) aufweist, das mit der zweiten Öffnung(6) des Kanals (2) der Speichereinrichtung ausrichtbar ist.

16. Vorrichtung nach Anspruch 15,
**gekennzeichnet durch** eine sockelartige Ausformung (40), deren Ausgestaltung zum Aufnehmen der zweiten sockelartigen Ausformung (14; 38) der Speichereinrichtung wenigstens weitgehend der Ausgestaltung der ersten sockelartigen Ausformung (13; 37) der Speichereinrichtung entspricht und **durch** die die Ausrichtung der zweiten Öffnung (6) des Kanals (2) der Speichereinrichtung mit dem Abfuhrelement(53) bewirkt ist.

17. Vorrichtung nach Anspruch 16,
**dadurch gekennzeichnet, daß** die sockelartige Ausformung (40) der Vorrichtung und das Abfuhrelement(53) gemeinsam mit einer im wesentlichen für eine radiale Vibrationsbewegung ausgebildeten zweiten Vibrationseinrichtung (52) gekoppelt sind.

18. Vorrichtung nach Anspruch 16 mit einer Speichereinrichtung nach Anspruch 4,
**dadurch gekennzeichnet, daß** die sockelartige Ausformung (40) der Vorrichtung mit einem Betätigungselement (33) ausgebildet ist, durch welches beim Zusammenfügen der zweiten sockelartigen Ausformung (14; 38) einer Speichereinrichtung mit der sockelartigenAusformung (40) der Vorrichtung das Verschlusselement (21) im Bereich der zweiten Öffnung (6) des Kanals (2) der Speichereinrichtung im Sinne eines Öffnens des Kanals (2) betätigbar ist.

19. Vorrichtung nach Anspruch 15, 16, 17 oder 18,
**gekennzeichnet durch** eine Stopeinrichtung (43) zum Unterbrechen der Zufuhr von Bauelementen (32) aus dem Kanal (2) einer gekoppelten Speichereinrichtung.

20. Vorrichtung nach Anspruch 16, 17, 18 oder 19,
**gekennzeichnet durch** eine im wesentlichen bajonettverschlußartige Ausbildung der sockelartigen Ausformung (40) der Vorrichtung.

## Claims

1. A storage device comprising a channel (2) for receiving components in a predefined sequence and alignment, in which storage device channel (2) is led between a first (3) and a second (5) end at least largely along a helical line around an inner body (1) and at the first end (3) is the connection to the exterior of the storage device by a first opening (4), where this first opening (4) at the first end (3) of the channel (2) is provided for filling the storage device with components, **characterized in that** the channel (2) is arranged for receiving chip-like electronic components (32) and a second opening (6) at the second end (5) of the channel (2) is provided for discharging the components (32) from the storage device, and also **characterized by** a first base-like projecting portion (13) formed in the inner body (1) in the region of the first end (3) of the channel (2) and a second base-like projecting portion (14) formed in the inner body (1) in the region of the second end (5) of the channel (2), which base-like projecting portions (13, 14) are arranged as each other's complement and where the second base-like projecting portion (38) of a first storage device can be joined to the first base-like projecting portion (13) of the second storage device for connecting the second opening (6) at the second end (5) of the channel (2) of the first storage device with the first opening (4) at the first end (3) of the channel (2) of the second storage device for the components (32) to pass through.

2. A storage device as claimed in claim 1, **characterized in that** the channel (2) runs, in essence, along a cylindrical helical line.

3. A storage device as claimed in claim 1, **characterized in that** the channel (2) runs, in essence, along a circular cylindrical helical line.

4. A storage device as claimed in claim 1, **characterized in that** the channel (2) is led over its total length along a circular cylindrical helical line whose pitch between the regions around the ends (3, 5) of the channel (2) has, in essence, a first value and whose pitch in the region of the ends (3, 5) of the channel (2) has a second value which is greater than this first value.

5. A storage device as claimed in any one of the claims 1 to 4 in which the channel (2) is led over its entire length along a cylindrical helical line, **characterized by** a construction with a cylindrical inner body (1; 36) which with an outer lateral area (7) is inserted into a cylindrical outer body (15) along an inner lateral area (16), the lateral areas (7, 16) having at least largely mutually adapted contours.

6. A storage device as claimed in claim 5, **characterized in that** the channel (2) is formed at least largely along the outer lateral area (7) in the inner body (1; 36).

7. A storage device as claimed in claim 5 or 6, **characterized in that** the first and the second base-like projecting portion (13, 14; 37, 38 respectively) of the storage device are adjusted to the inner body (1; 36 respectively) at least for an essential part.

8. A storage device as claimed in claim 5, 6 or 7, **characterized in that** the outer body (15) is formed of at least sections of a largely transparent material.

9. A storage device as claimed in one of the preceding claims, **characterized in that** the openings (4, 6) having each a locking element (21) are provided to lock the channel (2) to avoid components (32) included therein coming out.

10. A storage device as claimed in claim 9, **characterized in that** the locking elements (21) are spring-mounted.

11. A storage device as claimed in claim 9 or 10, **characterized by** a respective actuation element (41, 42) provided at each base-like projecting portion (13, 14; 37, 38), by which element the locking element (21) can be actuated in the region of the complementarily arranged base-like projecting portion (38, 37 respectively; 14, 13 respectively) of a further storage device when these two storage devices are joined in that the channel ((2) is opened.

12. A storage device as claimed in one of the preceding claims,
**characterized by** an, in essence, bayonet-catch design of the first and second base-like projecting portions (13, 14; 37, 38).

13. A device with a storage device as claimed in claim 1, in which the first base-like projecting portion (13; 37) of the storage device can be coupled to a first sub-assembly for preferably filling the storage device with components (32), which first sub-assembly has a channel-like feeding element (50) that can be aligned to the first opening (4) of the channel (2) of the storage device.

14. A device as claimed in claim 13, **characterized in that** the feeding element (50) is coupled to a first vibration device (51) in essence arranged for a linear vibration movement.

15. A device with a storage device as claimed in claim 1, in which the second base-like projecting portion (14; 38) can be coupled to a second sub-assembly for preferably unloading the components (32), which second sub-assembly has a channel-like discharge element (53) that can be aligned to the second opening (6) of the channel (2) of the storage device.

16. A device as claimed in claim 15, **characterized by** a base-like projecting portion (40) whose shape for accommodating the second base-like projecting portion (14; 38) of the storage device at least largely corresponds to the shape of the first base-like projecting portion (13; 37) of the storage device and by which the second opening (6) of the channel (2) of the storage device is aligned to the discharge element (53).

17. A device as claimed in claim 16 comprising a storage device as claimed in claim 4, **characterized in that** the base-like projecting portion (40) of the device and the discharge element (53) are jointly coupled to a second vibration device (52) in essence provided for a radial vibration movement.

18. A device as claimed in claim 16 including a storage device as claimed in claim 4, **characterized in that** the base-like projecting portion (40) of the device includes an actuating element (33) by which the locking element (21) in the region of the second opening (6) of the channel (2) of the storage device can be actuated **in that** the channel can be opened when the second base-like projecting portion (14; 38) of a storage device is joined to the base-like projecting portion (40) of the device.

19. A device as claimed in claim 15, 16, 17 or 18, **characterized by** a stop device (43) for interrupting the feeding of components (32) from the channel (2) of a coupled storage device.

20. A device as claimed in claim 16, 17, 18 or 19, **characterized by** an in essence bayonet-catch shape of the base-like projecting portion (40) of the device.

## Revendications

1. Dispositif de stockage avec un canal (2) pour le logement de composants dans un ordre et une orientation à déterminer préalablement dans lequel le canal (2) est guidé entre des première (3) et deuxième (5) extrémités le long d'une ligne hélicoïdale autour d'un corps interne (1), du moins en grande partie et est en contact sur la première extrémité (3) par une première ouverture (4) avec l'environnement extérieur du dispositif de stockage, cette première ouverture (4) étant prévue sur la première extrémité (3) du canal (2 pour le remplissage du dispositif de stockage en composants, **caractérisé en ce que** le canal (2) est conçu pour le logement de composants (32) électroniques en forme de puce et il est prévu une deuxième ouverture (6) à la deuxième extrémité (5) du canal (2) pour le déchargement des composants (32) du dispositif de stockage et **caractérisé par** une première déformation (13) en forme de socle formée dans le corps interne (1) dans la région de la première extrémité (3) du canal (3) et une deuxième déformation (14) en forme de socle formée dans le corps interne (1) dans la région de la deuxième extrémité (5) du canal (2), lesquelles déformations (13, 14) en forme de socle sont complémentaires l'une à l'autre et la deuxième déformation (38) en forme de socle d'un premier exemplaire du dispositif de stockage pouvant être combinée avec la première déformation (13) en forme de socle d'un deuxième exemplaire du dispositif de stockage pour la liaison continue pour les composants (32) de la deuxième ouverture (6) et la deuxième extrémité (5) du canal (2) du premier dispositif de stockage avec la première ouverture (4) à la première extrémité (3) du canal (2) du deuxième dispositif de stockage.

2. Dispositif de stockage selon la revendication 1,
**caractérisé en ce que** le canal (2) est guidé essentiellement le long d'une ligne hélicoïdale cylindrique.

3. Dispositif de stockage selon la revendication 1,
**caractérisé en ce que** le canal (2) est guidé essentiellement le long d'une ligne hélicoïdale cylindrique circulaire.

4. Dispositif de stockage selon la revendication 1,
**caractérisé en ce que** le canal (2) est guidé sur toute sa longueur le long d'une ligne hélicoïdale cylindrique circulaire dont la hauteur de pas présente essentiellement entre les zones autour des extrémités (3, 5) du canal (2) une première valeur et dont la hauteur de pas présente dans la région des extrémités (3, 5) du canal (2) une deuxième valeur supérieure à cette première valeur.

5. Dispositif de stockage selon l'une des revendications 1 à 4, dans lequel le canal (2) est guidé sur toute sa longueur le long d'une ligne hélicoïdale cylindrique,
**caractérisé par** une conception avec un corps interne (1; 36) cylindrique qui est inséré par une surface périphérique externe (7) le long d'une surface périphérique interne (16) d'un corps externe cylindrique (15) dans celui-ci, les surfaces périphériques (7, 16) présentant des contours adaptés, du moins en grande partie.

6. Dispositif de stockage selon la revendication 5,
**caractérisé en ce que** le canal (2) est formé, du moins en grande partie, le long de la surface périphérique externe (7) dans le corps interne (1; 36).

7. Dispositif de stockage selon l'une des revendications 5 ou 6,
**caractérisé en ce que** les première et deuxième déformations (13, 14 ou 37,38) en forme de socle du dispositif de stockage sont formées sur le corps interne (1 ou 36), du moins en majeure partie.

8. Dispositif de stockage selon l'une des revendications 5, 6 ou 7, **caractérisé en ce que** le corps externe (15) est formé, du moins par segments, d'un matériau transparent, du moins en grande partie.

9. Dispositif de stockage selon l'une des revendications précédentes, **caractérisé en ce que** les ouvertures (4, 6) sont conçues avec un élément de fermeture (21) respectif pour la fermeture du canal (2) contre la sortie de composants (32) qui y sont logés.

10. Dispositif de stockage selon la revendication 9,
**caractérisé en ce que** les éléments de fermeture (21) sont de conception élastique.

11. Dispositif de stockage selon l'une des revendications 9 ou 10,
**caractérisé par** un élément d'actionnement (41, 42) respectif conçu sur chaque déformation (13, 14; 37, 38) en forme de socle par lequel l'élément de fermeture (21) peut être actionné dans la région de la déformation (38 ou 37; 14 ou 13) en forme de socle de conception complémentaire d'un dispositif de stockage supplémentaire pour relier ces deux dispositifs de stockage dans le sens d'une ouverture du canal (2).

12. Dispositif de stockage selon l'une des revendications précédentes
**caractérisé par** une conception essentiellement en emboîtement à baïonnette des première et deuxième déformations (13, 14; 37, 38) en forme de socle.

13. Dispositif avec un dispositif de stockage selon la revendication 1,
dans lequel la première déformation (13, 37) en forme de socle du dispositif de stockage peut être couplée avec un premier groupe pour le remplissage de préférence du dispositif de stockage en composants (32), lequel premier groupe présente un élément d'approvisionnement (50) conçu en forme de canal qui peut être orienté avec la première ouverture (4) du canal (2) du dispositif de stockage.

14. Dispositif selon la revendication 13,
**caractérisé en ce que** l'élément d'approvisionnement (50) est couplé à un premier dispositif de vibration (51) essentiellement conçu pour un mouvement de vibration linéaire.

15. Dispositif avec un dispositif de stockage selon la revendication 1, dans lequel la deuxième déformation (14, 38) en forme de socle peut être couplée avec un deuxième groupe pour le déchargement de préférence des composants (32), lequel deuxième groupe présentant un élément d'évacuation (53) conçu en forme de canal qui peut être aligné avec la deuxième ouverture (6) du canal (2) du dispositif de stockage.

16. Dispositif selon la revendication 15,
**caractérisé par** une déformation (40) en forme de socle dont la conception pour le logement de la deuxième déformation (14; 38) en forme de socle du dispositif de stockage correspond, du moins en grande partie, à la conception de la première déformation (13; 37) en forme de socle du dispositif de stockage et par laquelle l'alignement de la deuxième ouverture (6) du canal (2) du dispositif de stockage est assuré avec l'élément d'évacuation (53).

17. Dispositif selon la revendication 16,
**caractérisé en ce que** la déformation (40) en forme de socle du dispositif et l'élément d'évacuation (53) sont couplés ensemble avec un deuxième dispositif de vibration (52) conçu essentiellement pour un mouvement radial de vibration.

18. Dispositif selon la revendication 16 avec un dispositif de stockage selon la revendication 4, **caractérisé en ce que** la déformation (40) en forme de socle du dispositif est conçue avec un élément d'actionnement (33) par lequel, lors de l'assemblage de la deuxième déformation (14; 38) en forme de socle d'un dispositif de stockage avec la déformation (40) en forme de socle du dispositif, l'élément de fermeture (21) peut être actionné dans la région de la deuxième ouverture (6) du canal (2) du dispositif de stockage dans le sens d'une ouverture du canal (2).

19. Dispositif selon l'une des revendications 15, 16, 17 ou 18,
**caractérisé par** un dispositif de blocage (43) pour l'interruption de l'apport des composants (32) du canal (2) d'un dispositif de stockage couplé.

20. Dispositif selon l'une des revendications 16, 17, 18 ou 19,
**caractérisé par** une conception essentiellement en emboîtement à baïonnette de la déformation (40) en forme de socle du dispositif.
